(19) Europäisches Patentamt / European Patent Office / Office européen des brevets

(11) **EP 1 911 058 B1**

(12) **EUROPÄISCHE PATENTSCHRIFT**

(45) Veröffentlichungstag und Bekanntmachung des Hinweises auf die Patenterteilung:
**03.12.2008 Patentblatt 2008/49**

(21) Anmeldenummer: **06762897.4**

(22) Anmeldetag: **28.07.2006**

(51) Int Cl.:
*H01H 47/00* (2006.01)    *G05B 9/03* (2006.01)
*H02H 1/04* (2006.01)    *H02P 23/00* (2006.01)
*H02P 1/28* (2006.01)    *H01H 9/54* (2006.01)

(86) Internationale Anmeldenummer:
**PCT/EP2006/007518**

(87) Internationale Veröffentlichungsnummer:
**WO 2007/014725 (08.02.2007 Gazette 2007/06)**

(54) **SICHERHEITSSCHALTGERÄT ZUM STEUERN EINER SICHERHEITSTECHNISCHEN EINRICHTUNG IN EINEN SICHEREN ZUSTAND**

SAFETY SWITCHING UNIT FOR CONTROLLING A SAFETY DEVICE INTO A SAFE STATE

COMMUTATEUR DE SECURITE POUR COMMANDER UN DISPOSITIF RELEVANT DE LA SECURITE, AFIN DE LE METTRE DANS UN ETAT DE SECURITE

(84) Benannte Vertragsstaaten:
**DE FR IT**

(30) Priorität: **02.08.2005 DE 102005036777**
**23.09.2005 DE 102005045753**
**12.01.2006 DE 102006001805**

(43) Veröffentlichungstag der Anmeldung:
**16.04.2008 Patentblatt 2008/16**

(60) Teilanmeldung:
**08017535.9**
**08017536.7**
**08017537.5**

(73) Patentinhaber: **Phoenix Contact GmbH & Co. KG**
**32823 Blomberg (DE)**

(72) Erfinder: **KORREK, Andre**
**37696 Marienmünster (DE)**

(74) Vertreter: **Kampfenkel, Klaus**
**Blumbach - Zinngrebe**
**Patentanwälte**
**Alexandrastrasse 5**
**65187 Wiesbaden (DE)**

(56) Entgegenhaltungen:
**EP-A- 0 610 711      EP-A- 0 772 216**
**EP-A- 1 363 306      EP-A- 1 484 780**
**WO-A-01/27954      DE-A1- 1 415 980**
**DE-A1- 10 016 712      DE-A1- 10 041 633**
**DE-A1- 19 601 540      DE-A1- 19 707 241**
**DE-B- 1 227 109      DE-C1- 10 127 233**
**GB-A- 489 810**

• **"NOT-AUS-SCHALTGERAETE, SCHUTZTUERWAECHTER" ANNOUNCEMENT PILZ NSG-D-1-051-07/00, Juli 2000 (2000-07), Seiten 1-4, XP000961973**

EP 1 911 058 B1

## Beschreibung

Die Erfindung betrifft ein Sicherheitsschaltgerät, mit welchem eine sicherheitstechnische Einrichtung, vorzugsweise ein elektrischer Antrieb, in einen sicheren Zustand gesteuert werden kann. Weiterhin betrifft die Erfindung eine dreiphasige Leistungsendstufe zum Ansteuern wenigstens einer Last, eine Messvorrichtung zum Messen eines periodischen Analogsignals, dessen Amplitude außerhalb eines vorbestimmten Arbeitsbereichs liegen kann, sowie eine Sicherheitsvorrichtung zum mehrkanaligen Steuern einer sicherheitstechnischen Einrichtung, die allesamt zum Einsatz in einem Sicherheitsschaltgerät geeignet sind.

Damit elektrische Antriebe, wie zum Beispiel ein Drehstrommotor, in Anwendungen oder Anlagen als eine sicherheitstechnische Komponente eingesetzt werden können, sind Sicherheitsrelais, Motoschutzschalter oder Motorschutzrelais und Schütze erforderlich, die den Antrieb in einen sicheren Zustand fahren können. Sicherheitsrelais dienen dazu, einen elektrischen Antrieb auszuschalten, sobald ein Notaus-, Schutztür- oder Zweihand-Schalter betätigt worden ist. Motorschutzschalter haben die Aufgabe, zum Beispiel bei thermischer Überlastung den Antrieb mit Hilfe von Bimetallen in einen sicheren Zustand zu fahren. Nachteilig an derartigen Sicherheitsmaßnahmen ist, dass die Bauteile einen großen Platzbedarf und erheblichen Verdrahtungsaufwand erfordern. Dies führt unter Anderem zu hohen Kosten und einem beträchtlichen Wartungsaufwand. Zudem zeigen die eingesetzten elektromagnetischen Schütze einen Kontaktverschleiß. Außerdem besteht die Gefahr, dass bei der Implementierung einer Anlage mit sicherheitstechnischen Komponenten Motorschutzschalter und Sicherheitsrelais falsch an die sicherheitstechnischen Komponenten angeschlossen werden oder defekte Bauteile verwendet werden, so dass die Anlage, der elektrische Antrieb und/oder Bedienpersonen durch einen Fehlbetrieb gefährdet werden können.

Der Erfindung liegt demzufolge die Aufgabe zugrunde, ein kompaktes Sicherheitsschaltgerät zu schaffen, welches die oben genannten Nachteile vermeidet und zudem sicherstellt, dass eine sicherheitstechnische Einrichtung, insbesondere ein elektrischer Antrieb, bei Auftritt eines Fehlers in der Anwendung, der Anlage, der sicherheitstechnischen Einrichtung und/oder dem Sicherheitsschaltgerät selbst schnell und zuverlässig in einen gewünschten sicheren Zustand überführt werden kann.

Ein Kerngedanke der Erfindung ist darin zu sehen, ein Sicherheitsschaltgerät mit einer integrierten programmierbaren Steuereinheit, wie zum Beispiel einem Mikroprozessor, einem Mikrocontroller oder einem FPGA (Field Programmable Gate Array) zu entwerfen, der zum Beispiel einen zu schützenden elektrischen Antrieb sowohl bei Betätigung eines Notaus-, Schutztür- und/oder Zweihand-Schalters als auch bei einem fehlerhaften Betrieb des Sicherheitsschaltgerätes oder des elektrischen Antriebs in einen sicheren Zustand steuern kann. Hierzu ist der Mikroprozessor vorzugsweise derart implementiert, dass er aus wenigstens einem zu messenden Analogsignal ermitteln kann, ob ein vorbestimmter Parameter, vorzugsweise die Amplitude des Analogsignals außerhalb eines vorbestimmten Arbeitsbereichs liegt. Zudem kann der Mikroprozessor Bestandteil einer Sicherheitseinrichtung sein, die zum mehrkanaligen Steuern eines sicherheitstechnischen elektrischen Antriebs ausgebildet ist. Auf diese Weise wird erreicht, dass das Sicherheitsschaltgerät auf zwei voneinander unabhängige Sicherheitsfunktionen ansprechen kann, um einen elektrischen Antrieb in einen sicheren Zustand zu steuern. Zudem ist bei einem derartigen kompakten Sicherheitsschaltgerät die Gefahr eines Verdrahtungsfehlers gegenüber den bekannten Maßnahmen deutlich reduziert.

Das oben genannte technische Problem wird durch die Merkmale des Anspruchs 1 gelöst.

Danach ist ein Sicherheitsschaltgerät zum Steuern wenigstens einer sicherheitstechnischen Einrichtung in einen gesicherten Zustand vorgesehen. Das Sicherheitsschaltgerät weist eine erste Anschlusseinrichtung zum Anschalten des Sicherheitsschaltgerätes an eine ein- oder mehrphasige Energieversorgungseinrichtung, wenigstens eine zweite Anschlusseinrichtung zum Anschalten einer sicherheitstechnischen Einrichtung, eine dritte Anschlusseinrichtung zum Anschalten wenigstens einer sicherheitstechnischen Eingangsstufe, eine zwischen der ersten und zweiten Anschlusseinrichtung geschalteten ein- oder mehrphasigen Leistungsendstufe mit wenigstens einem ansteuerbaren Schaltkontakt, eine Messeinrichtung und eine Sicherheitseinrichtung zum mehrkanaligen Ansteuern der, Leistungsendstufe auf. Die Sicherheitseinrichtung weist wiederum folgende Merkmale auf: eine erste, eine programmierbare Steuereinheit aufweisende Steuereinrichtung, die eine Signalerzeugungseinrichtung zum Erzeugen eines Überwachungssignals aufweist, eine zweiten Steuereinrichtung, wobei die Eingangsstufe mit der ersten Einrichtung und der zweiten Steuereinrichtung verbunden und zum Modulieren eines Eingangssignals mit dem von der ersten Steuereinrichtung kommenden Überwachungssignal ausgebildet ist, wobei die erste Steuereinrichtung und/oder die zweite Steuereinrichtung unter Ansprechen auf das modulierte Eingangssignal die sicherheitstechnische Einrichtung bei Auftritt eines Fehlers in einen vorbestimmten sicheren Zustand steuern, wobei die erste Steuereinrichtung der Messeinrichtung zugeordnet und derart ausgebildet ist, dass sie unter Ansprechen auf ein gemessenes Analogsignal die sicherheitstechnische elektrische Einrichtung über die Leistungsendstufe in einen vorbestimmten sicheren Zustand steuert, wenn ein vorbestimmter Parameter des gemessenen Analogsignals außerhalb eines vorbestimmten Arbeitsbereichs liegt.

Dank dieser Maßnahme ist es möglich, eine sicherheitstechnische Einrichtung in einen vorbestimmten sicheren Zustand zu fahren, und zwar dann, wenn

ein sicherheitstechnischer Schalter, wie zum Beispiel ein Notausschalter betätigt wird,

der Versorgungsstrom einen Schwellenwert überschreitet, oder ein Fehler in der sicherheitstechnischen Einrichtung oder im Sicherheitschaltgerät aufgetreten ist.

Vorteilhafte Weiterbildungen sind Gegenstand der abhängigen Ansprüche.

Vorzugsweise ist die Leistungsendstufe eine dreiphasige Leistungsendstufe, die einen ersten, zweiten und dritten Leiter aufweist, die über die erste Anschlusseinrichtung mit einer Drehstromversorgungseinrichtung verbindbar sind, wobei jedem Leiter wenigstens ein ansteuerbarer Schaltkontakt zum Öffnen und Schließen des jeweiligen Leiters zugeordnet ist, und wobei die Ansteuerung von wenigstens zwei der Schaltkontakte unabhängig voneinander erfolgt. In diesem Fall mißt die Messeinrichtung zum Beispiel den Leiterstrom in zwei Leitern und prüft, ob ein vorbestimmter Parameter wenigstens eines der beiden Ströme außerhalb des vorbestimmten Arbeitsbereichs liegt.

Die Messeinrichtung ist in der Lage alternativ oder zusätzlich eine Leiterspannung zu messen. Aus den gemessenen Spannungen und den zugehörenden Strömen kann die Messeinrichtung die Wirkleistung bestimmen. In diesem Fall kann das Sicherheitsschaltgerät nicht nur zum Personen- und Motorschutz, sondern auch zum Schutz der Anlage eingesetzt werden, da die Wirkleistung proportional des abgegebenen Drehmoments eines elektrischen Antriebs ist.

Um ein kompaktes, leicht handhabares Sicherheitsschaltgerät zu erhalten, bei welchem die Gefahr einer fehlerhaften Verdrahtung deutlich reduziert werden kann, sind die erste Anschlusseinrichtung, die wenigstens eine zweite Anschlusseinrichtung, die dritte Anschlusseinrichtung, die Leistungsendstufe, die Messeinrichtung und/oder die Steuereinrichtungen auf einer Leiterplatte angeordnet.

Gemäß einem weiteren Gesichtspunkt der Erfindung wird bei dem erfindungsgemäßen Sicherheitsschaltgerät eine Sicherheitsvorrichtung zum mehrkanaligen Steuern einer sicherheitstechnische Einrichtung integriert.

Automatisierungsanlagen umfassen in der Regel Feldbussysteme, an die sicherheitstechnische und nicht sicherheitstechnische Aktoren, Sensoren sowie über- und/oder untergeordnete Steuer- und Überwachungseinrichtungen angeschaltet sein können. Ein Aktor kann zum Beispiel einen elektrischen Antrieb, wie zum Beispiel einen Drehstrommotor enthalten. Eine wichtige Anforderung an derartige Automatisierungsanlagen ist, dass bei Auftritt eines Fehlers eine sicherheitstechnische Komponente, z. B. ein Aktor oder sogar die gesamte Automatisierungsanlage in einen gesicherten Zustand gefahren werden kann. Um ein sicheres Abschalten der Automatisierungsanlage oder eines fehlerhaften Aktors zu ermöglichen, muss sichergestellt sein, dass ein definiertes Eingangssignal, welches die Automatisierungsanlage in den sicheren Zustand fahren soll, immer korrekt interpretiert wird.

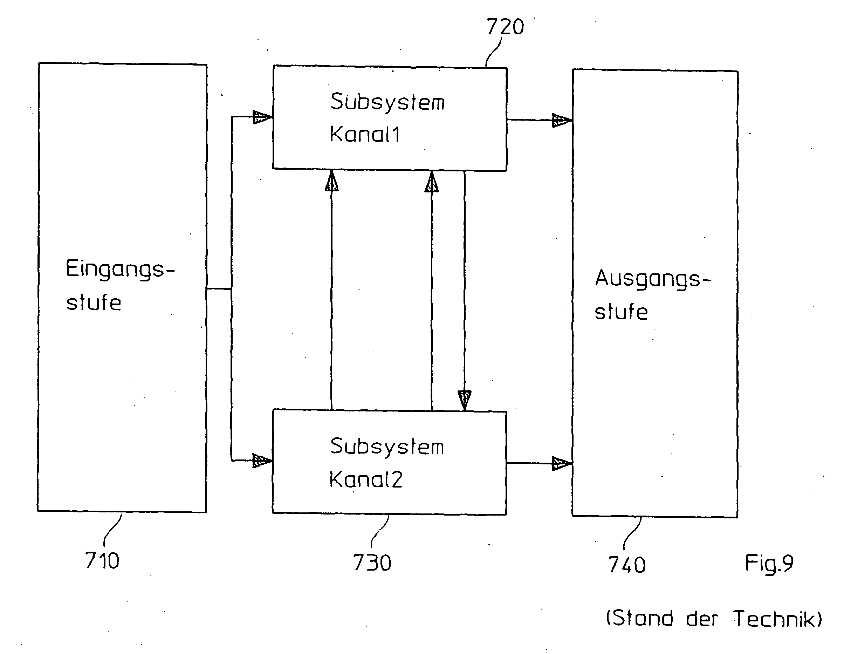

Bei Anlagen und Geräten, die zu einer bestimmten Sicherheitskategorie gehören, werden beispielsweise mehrkanalige Überwachungssysteme verwendet, die unabhängig voneinander arbeitende Subsysteme enthalten, die jeweils für sich die Anlage oder einzelne Geräte in einen gesicherten Zustand fahren können. Die mehrkanaligen oder redundant aufgebauten Überwachungssysteme sind weiterhin derart ausgebildet, dass die Subsysteme die Funktionsfähigkeit des jeweils anderen Subsystems überwachen können. Die gegenseitige Überwachung erfolgt in der Regel durch einen bidirektionalen Austausch von Statusdaten. Derartige bekannte mehrkanalige Überwachungssysteme sind symmetrisch aufgebaut. Das bedeutet, dass ein von einer Eingangsstufe geliefertes Eingangssignal, welches den Betriebszustand einer zu überwachenden Anlage steuert, unmittelbar an den Eingang jedes Subsystems des Überwachungssystems angelegt wird, wie dies in Fig. 9 gezeigt ist.

Ein Kerngedanke der Erfindung ist darin zu sehen, dass im Gegensatz zu bestehenden symmetrischen mehrkanaligen Überwachungssystemen, nachfolgend auch Sicherheitsvorrichtung genannt, bei denen das von einer Eingangsstufe bereitgestellte Eingangssignal unmittelbar an jedes Subsystem angelegt wird, das Eingangssignal in einer vorbestimmten Weise moduliert und anschließend den Subsystemen, nachfolgend auch Steuereinrichtungen genannt, zugeführt wird. Insbesondere erfolgt bei der erfindungsgemäßen Sicherheitsvorrichtung keine gegenseitige Überwachung der verschiedenen Steuereinrichtungen. Statt dessen fungiert eine mikroprozessorgesteuerte Steuereinrichtung als Master, welche die andere Steuereinrichtung, welche als Slave betrieben wird, überwacht.

Danach ist eine Sicherheitsvorrichtung zum mehrkanaligen Steuern einer sicherheitstechnischen Einrichtung vorgesehen. An dieser Stelle sei darauf hingewiesen, dass es sich bei einer sicherheitstechnischen Einrichtung um einen Aktor einer Automatisierungsanlage, eine ausführbare sicherheitstechnische Anwendung und/oder um eine Automatisierungsanlage selbst handeln.

Hierzu ist eine erste, mikroprozessorgesteuerte Steuereinrichtung vorgesehen, die einen ersten sogenannten Steuerkanal bildet. Die erste, mikroprozessorgesteuerte Steuereinrichtung weist eine Signalerzeugungseinrichtung zum Erzeugen eines Überwachungssignals auf. Ein zweiter Steuerkanal weist eine zweite Steuereinrichtung auf.

Das Überwachungssignal dient vor allem dazu, der Sicherheitsvorrichtung, insbesondere der zweiten Steuereinrichtung zu ermöglichen, die ordnungsgemäße Funktion der ersten, mikroprozessorgesteuerten Steuereinrichtung zu überwachen.

Mit der ersten, mikroprozessorgesteuerten Einrichtung und der zweiten Steuereinrichtung ist eine Eingangsstufe verbunden, die zum Modulieren eines Eingangssignals mit dem von der ersten mikroprozessorgesteuerten Steuereinrichtung kommenden Überwachungssignal ausgebildet ist. Die erste, mikroprozessorgesteuerte Steuereinrichtung und/oder die zweite Steuereinrichtung steuern unter Ansprechen auf das modulierte Eingangssignal die sicherheitstechnische Einrichtung,bei Auftritt eines Fehlers in einen vorbestimmten sicheren Zustand.

Die erste, mikroprozessorgesteuerte Steuereinrichtung führt vorzugsweise sicherheitsrelevante Programme oder Programmteile durch, um das modulierte Eingangssignal beispielsweise unter sicherheitstechnischen Gesichtspunkten zu verarbeiten. So kann das modulierte Eingangssignal zum Beispiel in definierter Weise codiert werden.

Die Signalerzeugungseinrichtung ist derart ausgebildet, dass sie in Abhängigkeit von der Abarbeitung wenigstens eines sicherheitsrelevanten Programms durch die erste, mikroprozessorgesteuerte Steuereinrichtung das Überwachungssignal erzeugt. An dieser Stelle sei angemerkt, dass die Signalerzeugungseinrichtung vorzugsweise Bestandteil eines Mikroprozessors der ersten, mikroprozessorgesteuerten Steuereinrichtung ist.

Die erste, mikroprozessorgesteuerte Steuereinrichtung und die zweite Steuereinrichtung sind mit einer Ausgangsstufe verbunden. Die Steuereinrichtungen weisen jeweils eine Einrichtung zum Aktivieren oder Deaktivieren der Ausgangsstufe auf. Insbesondere enthält die Ausgangsstufe wenigstens eine Schalteinrichtung, die ein Relais sein kann. Allerdings kann die Ausgangsstufe auch mehrere Schalteinrichtungen aufweisen, die ein stufenweises oder sanftes Abschalten einer sicherheitstechnischen Einrichtung ermöglichen.

Die Aktivierungs-/Deaktivierungseinrichtung der ersten, mikroprozessorgesteuerten Steuereinrichtung weist einen mit Masse verbindbaren Schalter auf, während die zweite Steuereinrichtung einen mit einer Versorgungsspannung verbindbaren Schalter aufweist. Alternativ kann natürlich auch die erste Steuereinrichtung einen mit einer Versorgungsspannung verbindbaren Schalter und die zweite Steuereinrichtung einen mit Masse verbindbaren Schalter aufweisen. Auf diese Weise können die Steuereinrichtungen unabhängig voneinander die Ausgangsstufe absteuern, um die sicherheitstechnische Einrichtung in den gesicherten Zustand zu versetzen. Je nach schaltungstechnischer Implementierung der Ausgangsstufe befindet sich eine sicherheitstechnische Einrichtung nur im Betriebszustand, wenn der durch die erste Steuereinrichtung definierte Massepfad zur Ausgangsstufe geschlossen und über die zweite Steuereinrichtung die Vorsorgungsspannung an die Ausgangsstufe angelegt ist. Die sicherheitstechnische Einrichtung kann dann über die Ausgangsstufe in einen sicheren Zustand gefahren werden, wenn entweder der Massepfad geöffnet und/oder die Versorgungsspannung von der Ausgangsstufe getrennt wird.

Vorzugsweise ist die erste, mikroprozessorgesteuerte Steuereinrichtung zum Überwachen der Eingangsstufe und/oder der zweiten Steuereinrichtung ausgebildet.

Die Modulation des Eingangssignals mit dem Überwachungssignal der ersten, mikroprozessorgesteuerten Steuereinrichtung kann mittels einer logischen Verknüpfungseinrichtung, insbesondere einem UND-Gatter durchgeführt werden. Alternativ kann auch ein gewöhnlicher Schalter, auch ein mechanischer Schalter verwendet werden, um das Überwachungssignal beim Öffnen und Schließen des Schalters zu modulieren.

Um eine Fehlfunktion der ersten und/oder zweiten Steuereinrichtung infolge eines fehlerhaften, unkontrollierten Oszillierens des Überwachungssignals zu vermeiden, muss die erste, mikroprozessorgesteuerte Steuereinrichtung eine geeignete Signalform liefern. Hierzu weist die erste, mikroprozessorgesteuerte Steuereinrichtung einen Modulator zum Modulieren des Überwachungssignals mit einem Signal auf, dessen Frequenz höher als die Frequenz des Überwachungssignals ist. Das höherfrequente Signal kann das Taktsignal des die erste Steuereinrichtung steuernden Mikroprozessors sein. In diesem Fall ist die Eingangsstufe zum Modulieren des modulierten Überwachungssignals und des Eingangssignals ausgebildet. Die zweite Steuereinrichtung muss in diesem Fall in der Lage sein, die unterschiedlichen Spektralanteile im modulierten Eingangssignal erfassen und auswerten zu können. Hierzu weist die zweite Steuereinrichtung einen Demodulator auf, der unter Ansprechen auf das von der Eingangsstufe kommende modulierte Eingangssignal und das von der ersten, mikroprozessorgesteuerten Steuereinrichtung kommende modulierte Überwachungssignal bei Auftritt eines Fehlers ein Steuersignal erzeugt, welches die sicherheitstechnische Einrichtung in den vorbestimmten sicheren Zustand steuert.

Hierzu fungiert der Demodulator zweckmäßigerweise als Bandsperre. In Verbindung mit wenigstens einer Schalteinrichtung, insbesondere einem Monoflop, liefert der Demodulator, wenn sich die Frequenz des Signals mit höherer Frequenz um einen vorbestimmten Betrag ändert, ein Steuersignal zum Steuern der sicherheitstechnischen Einrichtung in den sicheren Zustand.

Vorzugsweise weist der Demodulator ein Hochpassfilter und ein erstes Tiefpassfilter auf, dessen jeweiliger Eingang mit dem Ausgang der ersten, mikroprozessorgesteuerten Einrichtung verbunden ist. Ein erstes Monoflop ist vorgesehen, welches einen Reset-Eingang und einen Signaleingang aufweist, der mit dem Ausgang des Hochpassfilters verbunden ist. Ein zweites Tiefpassfilter ist vorgesehen, dessen Eingang mit dem negierten Ausgang des ersten Monoflops verbunden ist. Ferner ist ein zweites Monoflop vorgesehen, dessen Signaleingang mit dem Ausgang des ersten Tiefpassfilters und dessen Reset-Eingang mit dem Ausgang des zweiten Tiefpassfilters verbunden ist. Weiterhin ist ein drittes Monoflop vorgesehen, dessen Signaleingang mit dem Ausgang der Eingangsstufe und dessen Reset-Eingang mit dem negierten Ausgang des zweiten Monoflops verbunden ist.

Vorzugsweise ist die erste, mikroprozessorgesteuerte Steuereinrichtung softwarebasiert und die zweite Steuereinrichtung hardwarebasiert, d. h. schaltüngstechnisch realisiert. Ferner kann auch die zweite Steuereinrichtung durch einen Mikroprozessor gesteuert werden.

Bei dem Eingangssignal kann es sich um ein binäres Prozesssignal handeln, welches zum Anfahren und gesicherten Abschalten einer sicherheitstechnischen Einrichtung dient.

Gemäß einem weiteren Gesichtspunkt der Erfindung ist in erfindungsgemäßen dem Sicherheitsschaltgerät eine dreiphasige Leistungsendstufe integriert.

Dreiphasige Leistungsendstufen sind hinlänglich bekannt und dienen dazu, den von einem Drehstromgenerator erzeugten Drehstrom in gesteuerter Weise Lasten zur Verfügung zu stellen. Die Lasten können an eine Phase oder an alle drei Phasen der Leistungsendstufe angeschaltet und somit mit Wechselstrom bzw. Drehstrom versorgt werden.

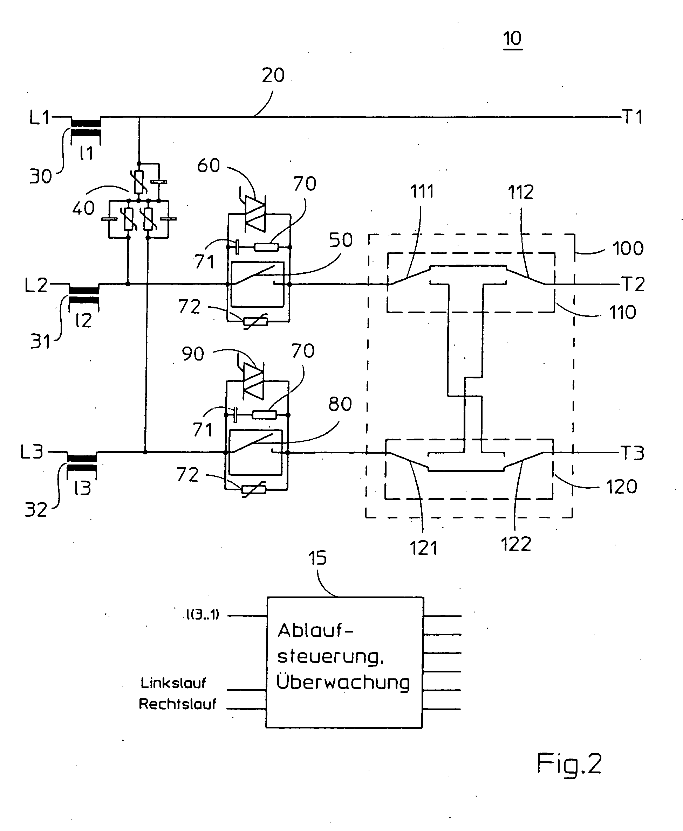

Eine bekannte dreiphasige Leistungsendstufe ist beispielsweise in Fig. 2 dargestellt. Die allgemein mit 10 bezeichnete Leistungsendstufe weist drei Leiter 20, 21 und 22, auch Phasen genannt, auf. In herkömmlicher Weise werden die zu einer nicht dargestellten Drehstromversorgungseinrichtung weisenden Leiterenden mit L1, L2 und L3 bezeichnet. Die Einspeisung eines Wechselstrom in die Leiter 30, 31 und 32 ist symbolisch durch einen Übertrager 30, 31 beziehungsweise 32 dargestellt. Um die elektronischen Bauelemente der Leitungsendstufe 10 und/oder die daran angeschalteten Lasten vor Überspannungen zu schützen, befindet sich zwischen den Leitern 20, 21 und 22 eine allgemein mit 40 bezeichnete Überspannungsschutzschaltung. Die Überspannungsschutzschaltung 40 kann mehrere Reihen- und/oder Parallelschaltungen aus Kondensatoren, Widerständen und/oder Varistoren aufweisen. Derartige Überspannungsschutzschaltungen sind bekannt und bedürfen somit keiner näher Erläuterung.

Die ausgangsseitigen Leiterenden werden in herkömmlicher Weise mit T1, T2 und T3 bezeichnet. Wie Fig. 2 zeigt, ist in den Leiter 21 ein Schaltkontakt 50 geschaltet, der Teil eines Relais ist. Parallel zum Schaltkontakt 50 ist ein als Wechselstromschalter fungierendes Halbleiterbauelement 60 geschaltet, welches durch einen Triac oder durch eine entsprechende Thyristor-Schaltung verwirklicht sein kann.

Parallel zum Triac 60 ist eine Schutzschaltung vorgesehen, die eine Reihenschaltung aus einem Widerstand 70 und einem Kondensator 71 und einen parallel dazu geschalteten Varistor umfassen kann. Die Schutzschaltung dient dazu, den Triac 60 und/oder Optotriacs, die die Zündspannung für die Triacs liefern, vor Spannungsspitzen zu schützen. Es sei darauf hingewiesen, dass derartige Schutzschaltungen für Halbleiterschalter, wie zum Beispiel den Triac 60, bekannt sind und somit nicht weiter erläutert werden müssen.

In den Leiter 22 ist ebenfalls ein Schaltkontakt 80 geschaltet, der zu einem separaten Relais gehört. Parallel zum Schaltkontakt ist wiederum ein Halbleiterschalter 90 in Form eines Triacs sowie eine Schutzschaltung in Form einer Reihenschaltung aus einem Widerstand 70 und einem Kondensator 71 sowie einem parallel dazu geschalteten Varistor 72 vorgesehen. Weiterhin ist zwischen den zweiten und dritten Leiter 21 und 22 eine Wendeschalteinrichtung 100 vorgesehen, die ein dem Leiter 21 zugeordnetes Relais 110 und ein dem Leiter 22 zugeordnetes Relais 120 aufweist. Das dem Leiter 21 zugeordnete Relais 110 weist zwei Schaltkontakte 111 und 112 auf, wohingegen das dem Leiter 22 zugeordnete Relais 120 Schaltkontakte 121 und 122 aufweist. Die Wendeschaltung 100 dient dazu, die Laufrichtung eines angeschlossenen Drehstrommotors zu ändern. Im dargestellten Schaltzustand verbinden die Schaltkontakte 111 und 112 des Relais 110 den Eingang L2 mit dem Ausgang T2 des Leiters 21, während die Schaltkontakte 121 und 122 des Relais 120 den Eingang L3 mit dem Ausgang T3 des Leiters 22 verbinden. Im angeschalteten Zustand dreht sich ein angeschlossener Drehstrommotor bei dieser Schaltkontaktstellung beispielsweise rechts herum. Werden die Relais 110 und 120 angesteuert, dann sorgen die jeweiligen Schaltkontakte 111 und 112 beziehungsweise 121 und 122 dafür, dass ein Wechselstrom über den Leiter 22 zum Ausgang des Leiters 21 und ein Wechselstrom vom Leiter 21 zum Ausgang des Leiters 22 geführt wird. Auf diese Weise wird die Laufrichtung eines angeschlossenen Drehstrommotors geändert.

Die bei der bekannten Leistungsendstufe eingesetzten Relais 110 und 120 der Wendeschaltung 110 sorgen dafür, dass die Leiter 21 und 22 ununterbrochen durchgeschaltet sind. Ein Abschalten der bekannten Leistungsendstufe 10 ist nur hinsichtlich der Leiter 21 und 22 möglich, indem die Schaltkontakte 50 und 80 geöffnet werden, so dass die den beiden Leitern zugeordneten Triacs 60 beziehungsweise 90 gesperrt betrieben werden. Da die Triacs allein einen Stromfluss durch die Leiter 21 und 22 sperren müssen, werden spezielle Halbleiterbauteile verwendet, die einer Sperrspannung von etwa 1200 V widerstehen können.

Die in Fig. 2 gezeigte bekannte Leistungsendstufe ist nicht geeignet, die Anforderungen der Sicherheitskategorie 3 zu erfüllen, da keine dreiphasige Abschaltung der Leistungsendstufe möglich ist. Denn in dem Leiter 20 ist kein Schalter vorgesehen, der den Leiter öffnen könnte.

Ein weiterer Aufgabe der Erfindung ist darin zu sehen, die eingangs genannte dreiphasige Leistungsendstufe derart weiter zu entwickeln, dass diese die Anforderungen der Sicherheitskategorie 3 sowie der Stop-Kategorien 0 und 1 erfüllt.

Ein weiterer Aufgabe der Erfindung ist darin zu sehen, im erfindungsgemäßen Sicherheitsschaltgerät eine neuartige Wendeschalteinrichtung zu gebrauchen, die die Verwendung von kostengünstigeren Halbleiterbauelementen für die bei der Leistungsendstufe eingesetzten Halbleiterschalter ermöglicht. Dank der neuartigen Wendeschalteinrichtung werden die Halbleiterschalter nämlich im gesperrten Zustand niedrigeren Sperrspannungen, d.h. etwa 800 V ausgesetzt als bei der in Fig. 2 gezeigten Leistungsendstufe, bei der die Sperrspannungen bei etwa 1200 V liegen. Ferner können die bei der bekannten dreiphasigen Leistungsendstufe nach Fig. 2 vorgesehenen Schutzschaltungen für die Halbleiterschalter bei der neuartigen Leistungsendstufe entfallen.

Eine weitere Aufgabe der Erfindung ist somit darin zu sehen, im erfindungsgemäßen Sicherheitsschaltgerät eine dreiphasige Leistungsendstufe zu schaffen, die vollständig abschaltbar ist und somit den Anforderungen der Sicherheitskategorie 3 genügt. Hierzu ist erforderlich, dass jeder Leiter der dreiphasigen Leistungsendstufe abgeschaltet werden kann.

Eine weitere Aufgabe der Erfindung ist darin zu sehen, im erfindungsgemäßen Sicherheitsschaltgerät die elektrische Belastung der eingesetzten Halbleiterschalter im abgeschalteten Betrieb der Leistungsendstufe zu verringern. Hierzu wird im erfindungsgemäßen Sicherheitsschaltgerät eine besondere Wendeschalteinrichtung verwendet, bei der beispielsweise zwei jeweils zwei Schaltkontakte aufweisende Relais parallel zwischen zwei Leiter geschaltet sind, derart, dass bei einer vorbestimmten Schaltkontaktstellung die beiden Leiter aufgetrennt sind. Ein Stromfluss durch diese beiden Leiter wird demzufolge nicht, wie beim Stand der Technik, allein durch die verwendeten Halbleiterschalter, sondern hauptsächlich durch die elektromechanischen Schaltkontakte der Wendeschalteinrichtung blockiert.

Danach ist in erfindungsgemäßen Sicherheitsschaltgerät eine dreiphasige Leistungsendstufe zum Ansteuern wenigstens einer Last, insbesondere eines Drehstrommotors vorgesehen, der einen ersten, zweiten und dritten Leiter aufweist. Eingangsseitig kann die dreiphasige Leistungsendstufe mit einer Drehstromversorgungseinrichtung verbunden werden. Damit die dreiphasige Leistungsendstufe den Anforderungen der Sicherheitskategorie 3 sowie der Kategorie 0-Stop oder 1-Stop genügen kann, ist jedem Leiter wenigstens ein Schaltkontakt zum Öffnen und Schließen des jeweiligen Leiters zugeordnet. Um das dreiphasige Abschalten der Leistungsendstufe sicherer gewährleisten zu können, werden wenigstens zwei der Schaltkontakte, die verschiedenen Leitern zugeordnet sind, unabhängig voneinander angesteuert.

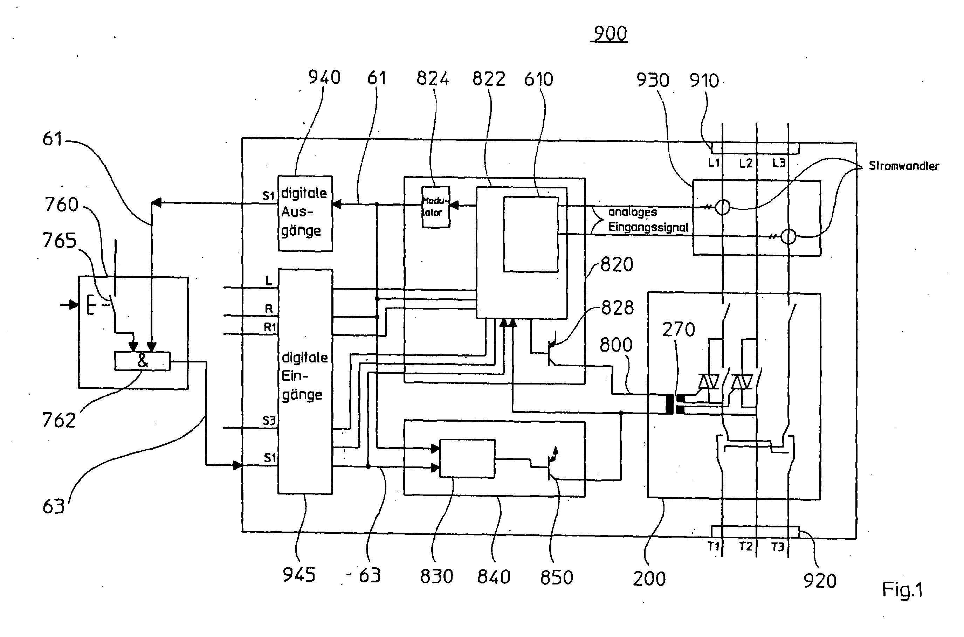

Wenigstens ein Schaltkontakt in jedem Leiter ist einem elektromagnetischen Schaltelement zugeordnet. Auf diese Weise ist sichergestellt, dass auch bei Verwendung von Halbleiterschaltern, zum Beispiel in dem zweiten und dritten Leiter, die Leiter mechanisch unterbrochen werden können. Da der Antrieb im abgeschalteten Zustand energiefrei ist, gibt es gegenüber der in Fig. 1 gezeigten Leistungsendstufe keine berührgefährlichen Spannungen.

Vorzugsweise ist zwischen dem zweiten und dritten Leiter ein erstes Schaltelement mit einem ersten und zweiten Schaltkontakten geschaltet, wobei der erste Schaltkontakt parallel zu einem der Halbleiterschalter und der zweite Schaltkontakt parallel zum anderen Halbleiterschalter geschaltet sind. Bei dem ersten und zweiten Schaltkontakt kann es sich jeweils um den erwähnten ansteuerbaren Schaltkontakt gemäß Anspruch 1 handeln.

Bei den Halbleiterschaltern kann es sich um Triacs, das sind Wechselstromschalter handeln, deren Zündenergie von einer Einrichtung bereitgestellt wird, die an eine Netzspannung angeschlossen ist. Die Einrichtung zum Bereitstellen der Zündenergie ist derart ausgebildet, dass sie die Halbleiterschalter für eine vorbestimmte Zeit im gezündeten Zustand hält, auch wenn zwischendurch der erste und zweite Schaltkontakt des ersten Schaltelements angesteuert wird. Dadurch wird sichergestellt, dass das zwischen dem zweiten und dritten Leiter angeordnete erste Schaltelement nahezu verschleißfrei geschaltet wird.

Um die Sperrspannung, die im abgeschalteten Zustand der dreiphasigen Leistungsendstufe an den Halbleiterschalter anliegt, reduzieren zu können - üblicherweise liegen 1000 V Sperrspannung an den Halbleiterschaltern an - ist zwischen zwei Leitern eine Wendeschalteinrichtung geschaltet, die zwei unabhängig voneinander ansteuerbare, jeweils einen ersten und zweiten Schaltkontakt aufweisende zweite Schaltelemente enthält, wobei die ersten Schaltkontakte der Schaltelemente an dem einen Leiter und die zweiten Schaltkontakte der Schaltelemente an dem anderen Leiter angeschaltet sind. In einer vorbestimmten Stellung der ersten und zweiten Schaltkontakte wird der Stromfluss durch die beiden Leiter gesperrt. Demzufolge lastet die Sperrfunktion nicht mehr ausschließlich bei den Halbleiterschaltern, sondern wird durch mechanische Schalter unterstützt. Demzufolge kann die Leistungsendstufe gegenüber der bekannten Leistungsendstufe nach Fig. 1 stromlos abgeschaltet werden.

Gemäß einer ersten Alternative sind die ersten Schaltkontakte der zweiten Schaltelemente der Wendeschalteinrichtung an dem zweiten Leiter und die zweiten Schaltkontakte der zweiten Schaltelemente an dem dritten Leiter angeschaltet.

Vorzugsweise wird bei der ersten Alternative ein drittes Schaltelement mit wenigstens zwei Schaltkontakten an den ersten Leiter angeschlossen. Auf diese Weise ist sichergestellt, dass in jedem Leiter der dreiphasigen Leistungsendstufe mindestens zwei Schaltkontakte vorgesehen sind. Dadurch wird sichergestellt, dass die dreiphasige Leistungsendstufe die Stop-Kategorie 0 und Stop-Kategorie 1-Bedingungen erfüllt. Denn selbst bei Ausfall eines Schaltkontaktes ist ein sicheres dreiphasiges Abschalten der Leistungsendstufe immer noch möglich.

Eine alternative Verschaltung der Wendeschalteinrichtung sieht vor, dass die ersten Schaltkontakte der beiden zweiten Schaltelemente an dem ersten Leiter und die zweiten Schaltkontakte der beiden zweiten Schaltelemente an dem dritten Leiter angeschaltet sind.

Der Sicherheitsgrad kann beim Abschalten der Leistungsendstufe gemäß der zweiten Alternative gegenüber der ersten Alternative dadurch gesteigert werden, dass ein drittes Schaltelement mit einem ersten und zweiten Schaltkontakt vorgesehen ist, wobei der erste Schaltkontakt an den ersten Leiter und der zweite Schaltkontakt an den zweiten Leiter angeschlossen ist. Dadurch wird sichergestellt, dass in jedem Leiter jeweils zwei unabhängig voneinander ansteuerbare Schaltkontakte und Halbleiterschalter vorgesehen sind.

Dadurch, dass in der Leistungsendstufe vorzugsweise nur Relais mit jeweils zwei Schaltkontakten eingesetzt werden, bleibt die Anzahl verwendeter Relais gegenüber der in Fig. 1 gezeigten Leistungsendstufe bei deutlich verbesserter Sicherheit gleich.

Herkömmlicherweise sind die Halbleiterschalter durch jeweils eine Schutzeinrichtung vor Überspannungen und anderen elektrischen Störungen geschützt. An dieser Stelle sei darauf hingewiesen, dass die besondere Verschaltung der Wendeschalteinrichtung und die Verwendung eines elektromechanischen Schaltelements, dessen beide Schaltkontakte entweder in dem Leiter 1 oder jeweils in dem ersten und zweiten Leiter angeschlossen sind, einen Einsatz von Halbleiterschaltern auch ohne Schutzschaltungen ermöglichen.

In an sich bekannter Weise kann zwischen den drei Leitern eine Schutzschaltung gegen Überspannungen geschaltet sein.

Zum ordnungsgemäßen An- und Abschalten der dreiphasigen Leistungsendstufe ist eine Steuereinrichtung, gegebenenfalls auch eine programmierbare Steuereinrichtung, zum Ansteuern der Schaltelemente und Halbleiterschalter vorgesehen.

Um beim Auftreten eines Fehlers die dreiphasige Leistungsendstufe schnell und zuverlässig abschalten zu können, ist eine Überwachungseinrichtung vorgesehen, die den in den Leitern fließenden Strom, die zwischen den Leitern anliegende Ausgangsspannungen und/oder die Laufrichtung wenigstens eines angeschlossenen Drehstrommotors überwachen kann, wobei die Steuereinrichtung unter Ansprechen auf die Überwachungseinrichtung die jeweiligen Schaltelemente und Halbleiterschalter ansteuert.

Das eingangs genannte technische Problem wird ebenfalls durch eine Wendeschaltanordnung gelöst, die insbesondere für eine dreiphasige Leistungsendstufe vorgesehen ist. Die Wendeschaltanordnung weist zwei unabhängig voneinander ansteuerbare, jeweils einen ersten und zweiten Schaltkontakt aufweisende Schaltelemente auf. Die ersten Schaltkontakte der Schaltelemente sind an einen ersten Leiter und die zweiten Schaltkontakte an einen zweiten Leiter angeschaltet. Die Verschaltung und Anordnung der Schaltkontakte ist derart gewählt, dass in einer vorbestimmten Stellung der ersten und zweiten Schaltkontakte der Stromfluss durch die angeschlossenen Leiter gesperrt.

Gemäß einem weiteren Aspekt der Erfindung ist in dem erfindungsgemäßen Sicherheitsschaltgerät eine Vorrichtung zum Messen eines periodischen Analogsignals integriert.

Der Schutz elektrischer Antriebe, wie zum Beispiel Motoren, gegen Überströme oder Überspannungen erfolgt heute vornehmlich durch mechanische Überwachungselemente auf Basis von Bimetallen. Die Auslösecharakteristik von mechanischen Bimetallen wird dabei durch die verwendeten Metalle sowie den Wärmeübertragung der vom Motorstrom durchflossenen Glühkerzen bestimmt. Obwohl temperaturabhängige Kompensationsschaltungen eingesetzt werden, kann das Auslöseverhalten mechanischer Bimetalle durch Schwankungen der Umgebungstemperatur verfälscht werden. Darüber hinaus sind derartige mechanische Überwachungselemente extrem anfällig gegenüber Verschmutzungen und Verschleiß ihrer Komponenten, so dass Überwachungselemente häufig geprüft und gewartet werden müssen.

Demzufolge wurden in den vergangenen Jahren immer häufiger -elektronische Bimetallschalter als Überwachungselemente eingesetzt. Diese arbeiten wesentlich präziser und haben im Vergleich zu mechanischen Überwachungselementen keinen nennenswerten Verschleiß und sind unempfindlicher gegenüber äußeren Beeinflussungen.

Allerdings werden bei der Verwendung elektronischer Bimetallschalter Messgeräte eingesetzt, die bei der Auslösung der elektronischen Bimetallschalter erforderlich sind. Die eingesetzten Messgeräte müssen unter anderem den sogenannten "Inrush" erfassen können, der das Siebenfache des Motornennstroms betragen kann, und ferner auch im Nennstrombereich eines Motors noch eine ausreichende Auflösung und Genauigkeit besitzen. Demzufolge ist eine aufwendige und komplexe Dimensionierung der Messgeräte erforderlich, damit sie Ströme innerhalb eines möglichst großen Strombereichs, d. h. Nennströme und Überströme erfassen können. Dies führt zu sehr großen und teuren Messgeräten, da insbesondere die Stromwandler entsprechend überdimensioniert werden müssen.

Eine weitere Aufgabe der Erfindung ist darin zu sehen, im erfindungsgemäßen Sicherheitsschaltgerät eine Messvorrichtung und ein Messverfahren bereit zu stellern, mit denen beim Auftreten insbesondere eines Überstroms dessen Spitzenamplitude unter Berücksichtigung einer bekannten Kurvenform geschätzt werden kann. Auf diese Weise ist es möglich, Messgeräte auch außerhalb des vorgegebenen Mess- oder Arbeitsbereichs zu betreiben, auch wenn das Messgerät nur für Nennströme, die innerhalb des vorgegebenen Messbereichs liegen, dimensioniert ist.

Der Erfindung liegt somit ferner die Aufgabe zugrunde, im erfindungsgemäßen Sicherheitsschaltgerät ein Messverfahren und eine Messvorrichtung zur Verfügung zu stellen, die für den Nennstrombereich einer elektrischen Einrichtung ausgelegt sind und demzufolge mit kostengünstigen elektrischen und elektromagnetischen Baukomponenten aufgebaut werden können und dennoch Überströme erfassen können.

Danach ist eine Messvorrichtung zum Messen eines periodischen analogen Signals vorgesehen, dessen Amplitude außerhalb eines vorbestimmten Arbeitsbereichs liegen kann. Die Messvorrichtung weist eine Einrichtung zum Ermitteln der Zeitdauer, während der die Amplitude des zu messenden Analogsignals betragsmäßig größer oder gleich einem vorbestimmten Schwellenwert ist, sowie eine Auswerteeinrichtung auf, die aus der ermittelten Zeitdauer und der Signalform, insbesondere der Signalfrequenz des zu messenden Analogsignals dessen maximale Amplitude berechnet.

An dieser Stelle sei erwähnt, dass unter "vorbestimmten Arbeitsbereich" der Bereich zu versehen ist, innerhalb dessen Messsignale das Messgerät, d. h. ein oder mehrere elektrische' Komponenten, aus denen das Messgerät aufgebaut ist, nicht in die Sättigung fahren und somit in herkömmlicher Weise gemessen werden können. Der Begriff "betragsmäßig größer" berücksichtigt den Umstand, dass ein periodisches Analogsignal einen maximalen und minimalen Spitzenwert aufweist, der über- bzw. unterschritten werden kann.

Zweckmäßigerweise weist die Ermittlungseinrichtung der Messvorrichtung eine Abtasteinrichtung zum Abtasten des zu messenden Analogsignals mit einer Abtastfrequenz sowie eine Einrichtung zum Erfassen und Zählen von aufeinander folgenden Abtastwerten auf, welche betragsmäßig größer oder gleich dem vorbestimmten Schwellenwert sind. In diesem Fall ist die Auswerteeinrichtung zum Berechnen der maximalen Amplitude des Analogsignals in Abhängigkeit von der Anzahl der gezählten Abtastwerte, der Abtastfrequenz und der Signalfrequenz ausgebildet.

An dieser Stelle sei erwähnt, dass der Schwellwert zum Beispiel der obere und/oder untere Grenzwert des vorbestimmten Arbeitsbereichs der Messvorrichtung sein kann, innerhalb dessen eine herkömmliche Messung des Analogsignals möglich ist. Allerdings kann der Schwellwert auch um einen vorbestimmten Betrag betragsmäßig kleiner als der obere und/oder untere Grenzwerte sein.

Handelt es sich bei dem Analogsignal um ein sinusförmiges Signal mit einer vorbestimmten Signalfrequenz, so kann die Auswerteeinrichtung den maximalen Amplitudenwert unter Verwendung der Gleichung

$$I = \frac{1}{\sin\left(\pi\left(\frac{1}{2} - \frac{T_{AB} * N}{T}\right)\right)}$$

berechnen. In der Gleichung ist $T_{AB}$ der Kehrwert der Abtastfrequenz, N die Anzahl gezählter Abtastwerte, welche betragsmäßig größer oder gleich dem vorbestimmten Schwellenwert sind, und T die Periodendauer des zu messende Analogsignals ist.

Um die Rechenleistung der Auswerteeinrichtung reduzieren zu können, ist eine alternative Messvorrichtung vorgesehen, wie sie in Anspruch 4 umschrieben ist.

Danach weist die Messvorrichtung eine Einrichtung zum Abtasten des Analogsignals mit einer Abtastfrequenz auf. Ferner ist eine Einrichtung zum Erfassen und Zählen von aufeinander folgenden Abtastwerten, welche betragsmäßig größer oder gleich einem vorbestimmten Schwellenwert sind, vorgesehen. In einer Speichereinrichtung sind der maximale, außerhalb des vorbestimmten Arbeitsbereichs liegende Amplitudenwert mehrerer Referenzsignale und die jeweils dazu gehörende Anzahl von gezählten Abtastwerten, welche betragsmäßig größer oder gleich einem vorbestimmten Schwellenwert sind, abgelegt. Ferner weist die Messvorrichtung eine Auswerteeinrichtung auf, die unter Ansprechen auf die von der Erfassungs- und Zähleinrichtung ermittelte Anzahl von Abtastwerten den dazu gehörenden maximalen Amplitudenwert aus der Speichereinrichtung ausliest. Hierzu kann die ermittelte Anzahl als Speicheradresse verwendet. An dieser Stelle sei betont, dass es sich bei dem maximalen Amplitudenwert um einen berechneten Amplitudenwert handelt, der als Schätzwert für den tatsächlichen maximalen Amplitudenwert anzusehen ist, welcher ein zu messendes Signal, welches außerhalb des vorbestimmten Arbeitsbereichs liegt, hat.

Um die Abtastwerte digital auswerten zu können, ist ein AD-Umsetzer zum Umsetzen der Abtastwerte in entsprechende Digitalwerte vorgesehen.

Der maximale Amplitudenwert kann um so genauer berechnet werden, je höher die Abtastfrequenz des Abtasteinrichtung gewählt wird. Gleichzeitig nimmt jedoch der Rechenaufwand zu. Demzufolge ist es zweckmäßig, dass die Abtastfrequenz einstellbar ist.

Die Messvorrichtung kann in einer gegen Überströme gesicherten Vorrichtung, insbesondere bei elektrischen Antrieben, zum Einsatz kommen, wobei die gegen Überströme gesicherte Vorrichtung eine Auslöseeinrichtung aufweist, die unter Ansprechen auf den berechneten maximalen Amplitudenwert die Vorrichtung ausschalten kann.

Das obengenannte technische Problem wird ebenfalls durch ein Verfahren zum Messen eines periodischen Analogsignals gelöst, dessen Amplitude außerhalb eines vorbestimmten Arbeitsbereichs liegen kann, zur Verfügung gestellt. Zunächst wird die Zeitdauer, während der die Amplitude des zu messenden Analogsignals betragsmäßig größer oder gleich einem vorbestimmten Schwellenwert ist, ermittelt. In Abhängigkeit von der ermittelten Zeitdauer und der Signalform, insbesondere der Signalfrequenz des zu messenden Messsignals, wird dann die maximale Amplitude des zu messenden Analogsignals, welches außerhalb des vorbestimmten Arbeitsbereichs liegt, berechnet.

Die Zeitdauer kann ermittelt werden, indem das zu messende Analogsignal mit einer Abtastfrequenz abgetastet wird. Aufeinander folgende Abtastwerte, welche betragsmäßig größer oder gleich einem vorbestimmten Schwellenwert sind, werden dann gezählt. In Abhängigkeit von der Anzahl der gezählten Abtastwerte, der Abtastfrequenz und der Signalfrequenz wird die maximale Amplitude des Analogsignals berechnet.

Um den schaltungstechnischen Aufwand und den Zeitaufwand beim Berechnen des maximalen Amplitudenwertes zu reduzieren, werden vorab für mehrere Referenzsignale jeweils die maximale Amplitude, welche außerhalb des vorbestimmten Arbeitsbereichs liegt, und die dazu gehörende Anzahl von Abtastwerten, die betragmäßig größer oder gleich einem Schwellenwert sind, ermittelt und gespeichert. Nunmehr wird ein zu messendes Analogsignal mit einer Abtastfrequenz abgetastet. Die aufeinander folgenden Abtastwerte, welche betragsmäßig größer oder gleich dem vorbestimmten Schwellenwert sind, werden gezählt, und der zur Anzahl der gezählten Abtastwerte gehörende maximale Amplitudenwert wird ausgelesen.

Die Erfindung wird nachfolgend anhand mehrerer Ausführungsbeispiele in Verbindung mit den beiliegenden Zeichnungen näher erläutert. In den Zeichnungen werden für gleiche Bauteile oder Komponenten die gleichen Bezugszeichen verwendet. Es zeigen:

| | |
|---|---|
| Fig. 1 | ein Sicherheitsschaltgerät gemäß der Erfindung, |
| Fig. 2 | eine dreiphasige Leistungsendstufe nach dem Stand der Technik, |
| Fig. 3 | eine gezeigte dreiphasige Leistungsendstufe die im Sicherheitsschaltgerät gemäß der Erfindung angewendet wird, |
| Fig. 4 Fig. 4 | eine alternative dreiphasige Leistungsendstufe die im Sicherheitsschaltgerät gemäß der Erfindung angewendet wird, |
| Fig. 5 | eine schematische Darstellung einer dreiphasigen Leistungsendstufe die im Sicherheitsschaltgerät gemäß der Erfindung ohne Verwendung einer Wendeschalteinrichtung angewendet wird, |
| Fig. 6 | ein Ausführungsbeispiel eines Messgeräts der im Sicherheitsschaltgerät nach der Erfindung angewendet wird, |
| Fig. 7 | ein abgetastete Messsignal innerhalb des zulässigen Messbereichs, |
| Fig. 8 | ein abgetastetes Messsignal, das außerhalb des zulässigen Messbereichs liegt, |
| Fig. 9 | ein vereinfachtes Blockschaltbild einer zweikanaligen symmetrischen Sicherheitsvorrichtung gemäß dem Stand der Technik, |
| Fig. 10 | ein vereinfachtes Blockschaltbild einer Sicherheitsvorrichtung zum mehrkanaligen Steuern einer sicherheitstechnischen Einrichtung gemäß einer ersten Ausführungsform, die im erfindungsgemäßen Sicherheitsschaltgerät angewendet wird, |
| Fig. 11 | den zeitlichen Verlauf des Überwachungssignals, welches die erste, mikroprozessorgesteuerte Steuereinrichtung der in Fig. 10 gezeigten Sicherheitsvorrichtung erzeugt, |
| Fig. 12 | den prinzipiellen Schaltungsaufbau der in Fig. 10 gezeigten zweiten Steuereinrichtung, |
| Fig. 13 | eine alternative Sicherheitsvorrichtung zum mehrkanaligen Steuern einer sicherheitstechnischen Einrichtung die im Sicherheitsschaltgerät gemäß der Erfindung angewendet wird, |
| Fig. 14 | den prinzipiellen Schaltungsaufbau der in Fig. 13 gezeigten zweiten Steuereinrichtung, |
| Fig. 15a bis Fig. 15i | verschiedene Signalverläufe innerhalb der in Fig. 14 gezeigten Schaltungsanordnung an vorbestimmten Punkten während eines fehlerfreien Betriebs, |
| Fig. 16a bis Fig. 16i | verschiedene Signalverläufe innerhalb der in Fig. 14 gezeigten Schaltungsanordnung an vorbestimmten Punkten während eines fehlerhaften Betriebs, und |
| Fig. 17a bis Fig. 17i | verschiedene Signalverläufe innerhalb der in Fig. 14 gezeigten Schaltungsanordnung an vorbestimmten Punkten während eines fehlerhaften Betriebs. |

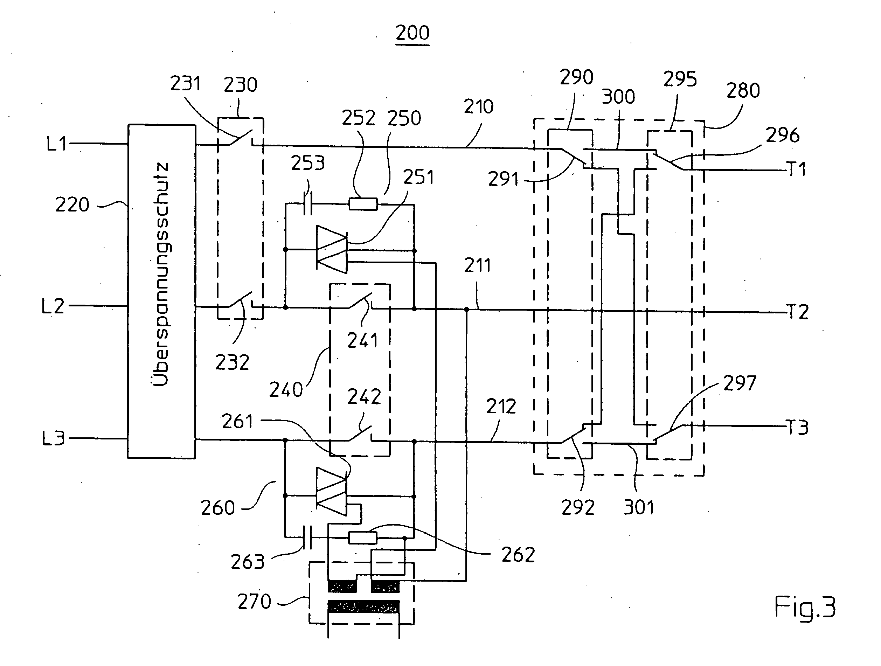

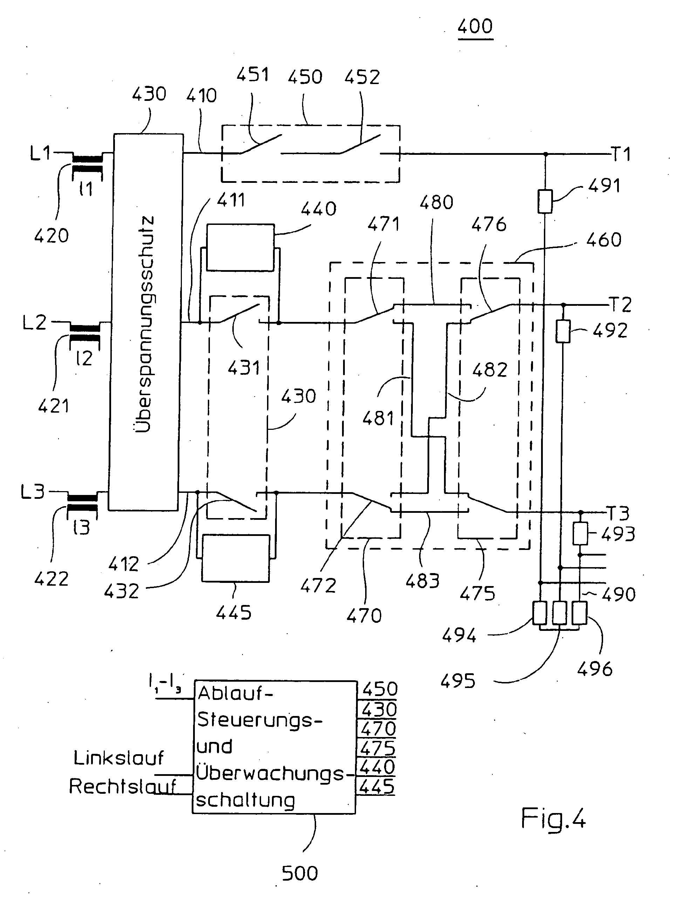

In Figur 1 ist das Blockschaltbild eines beispielhaften Sicherheitsschaltgerät 900 dargestellt, dessen Komponenten in einem Gehäuse untergebracht sein können. Das Sicherheitsschaltgerät 900 weist eine erste Anschlusseinrichtung 910 auf, über die das Sicherheitsschaltgerät 900 beispielsweise an ein dreiphasiges Energieversorgungsnetz (nicht dargestellt) angeschaltet werden kann. Die drei mit dem Energieversorgungsnetz verbundenen Eingangsleiter sind in Figur 1 mit L1, L2 und L3 bezeichnet. Die drei Leiter L1, L2 und L3 sind mit einer Leistungsendstufe 200 verbunden, deren drei ausgangsseitigen Leiter T1, T2 und T3 bezeichnet sind. Die drei ausgangseitigen Leiter sind mit einer zweiten Anschlusseinrichtung 920 verbunden, an die eine sicherheitstechnische Einrichtung, beispielsweise ein Drehstrommotor angeschlossen werden kann. Denkbar ist es, dass an das Sicherheitsschaltgerät 900 auch mehrere sicherheitstechnische Einrichtungen, wie z. B. ein- oder weitere mehrphasige Antriebe angeschlossen werden können. Dementsprechend ist die verwendete Leistungsendstufe ein- oder mehrphasig ausgebildet. Die Leistungsendstufe 200 ist der einfachen Darstellung wegen nur schematisch dargestellt. Die Leistungsendstufe 200 wird später im Zusammenhang mit Figur 3 näher erläutert. An dieser Stelle sei angemerkt, dass anstelle der in Fig. 3 dargestellten Leistungsendstufe auch die in Fig. 4 dargestellte Leistungsendstufe 400 eingesetzt werden kann.

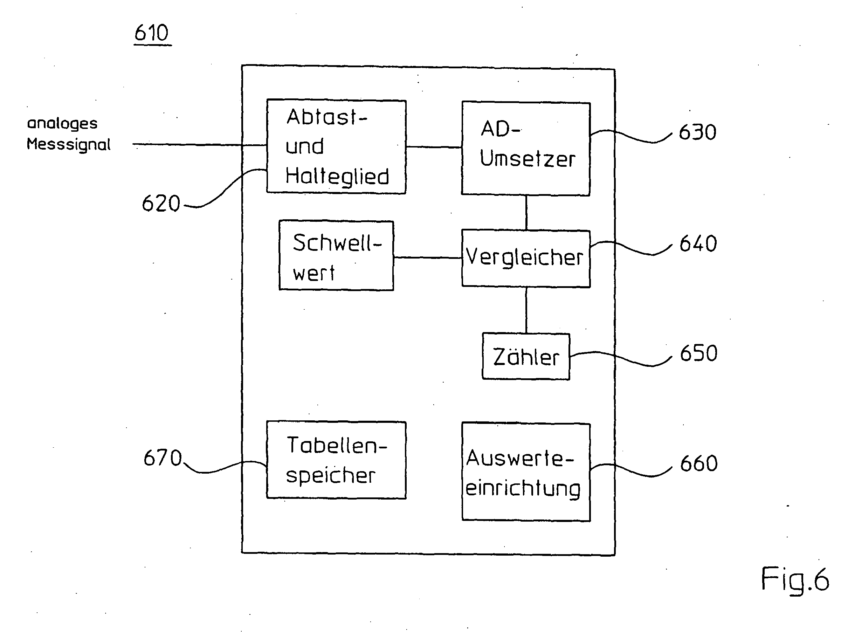

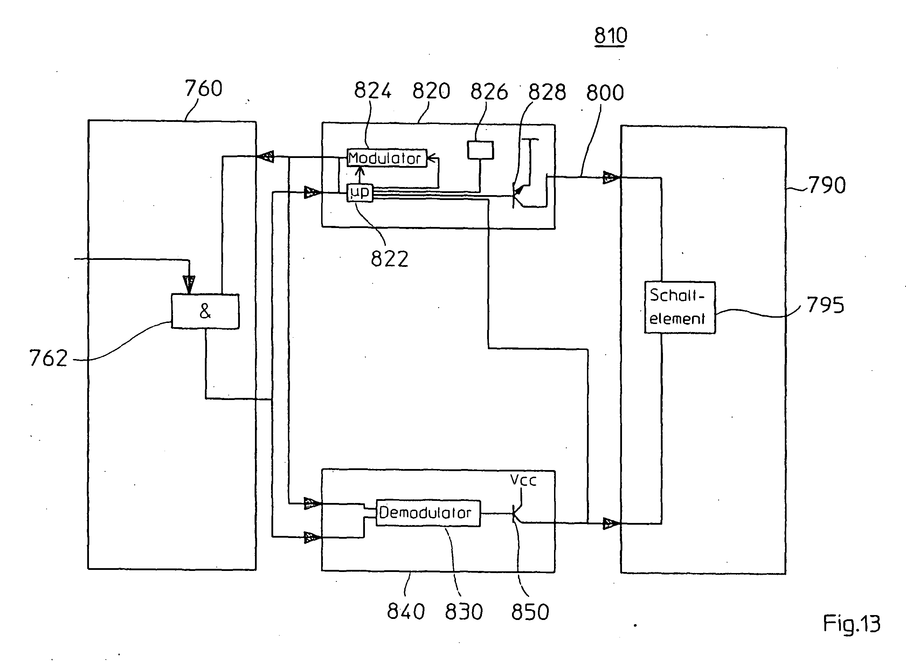

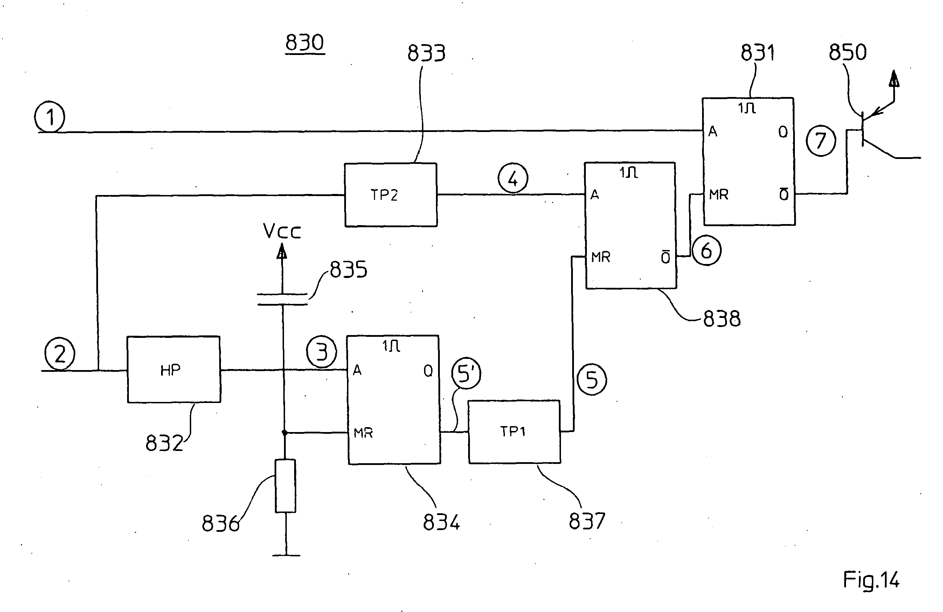

In die Eingangsleiter L1, L2 und L3 ist eine Einrichtung 930 mit Stromwandlern in den Leitern L1 und L3 geschaltet, die den analogen Strom in den Leitern L1 und L3 einer Messeinrichtung 610 zuführen. Die Messeinrichtung 610 kann Bestandteil einer programmierbaren Steuereinheit, zum Beispiel eines Mikrokontrollers oder Mikroprozessors 822 einer Steuereinrichtung 820 sein. Sie kann jedoch auch als separates Funktionsmodul ausgebildet sein. Bei der Messeinrichtung 610 handelt es sich vorzugsweise um die in Verbindung mit den Fig. 6 bis 8 erläuterte Messeinrichtung 610. Hauptaufgabe der Messeinrichtung ist darin zu sehen, festzustellen, ob die Amplitude der Ströme in den Leitern L1 und L3 außerhalb eines vorbestimmten Arbeitsbereichs liegen. Wenn dies der Fall ist, steuert der Mikroprozessor 822 über einen Schalttransistor 828 die Leistungsendstufe 200 ab, um den angeschalteten Drehstrommotor von dem nicht dargestellten Energieversorgungsnetz zu trennen. Wie in der Figur 1 schematisch dargestellt, ist der Schalttransistor 828 mit einem Übertrager 270 der Leistungsendstufe 200 verbunden. Die Mikroprozessor gesteuerte Steuereinrichtung 820 wird später anhand der Figuren 13 und 14 detaillierter beschrieben. Alternativ oder zusätzlich ist es möglich, in die Leiter L1 und L3 Spannungswandler einzuschleifen, die Leiterspannungen der Messeinrichtung 610 zuführen. Die Messeinrichtung 610 kann derart ausgebildet sein, dass sie aus den empfangenen Spannungssignalen durch die Multiplikation mit den zugehörigen Stromsignalen die Wirkleistung ermittelt und prüft, ob die Wirkleistungen innerhalb oder außerhalb eines vorbestimmten Arbeitsbereichs liegen. Die tatsächlichen Werte des Arbeitsbereiches und die Zeitdauer, wie lange die Stromamplituden außerhalb des vorbestimmten Arbeitsbereiches liegen dürfen, ohne dass eine Abschaltung des Drehstrommotors erfolgt, können von einer Bedienperson eingestellt werden.

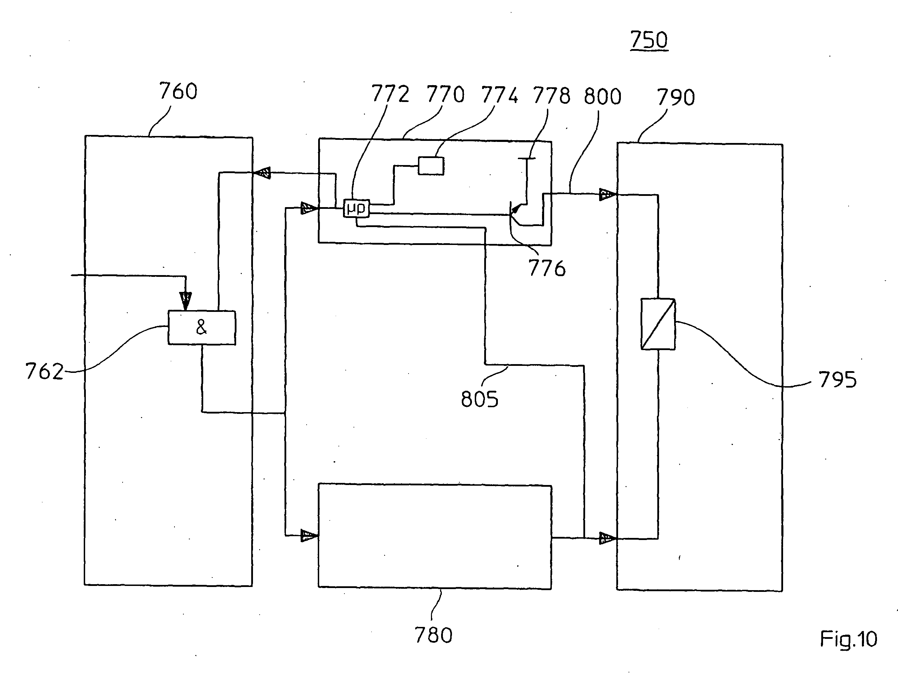

Weiterhin umfasst das Sicherheitsschaltgerät 900 eine weitere Steuereinrichtung 840 die einen Demodulator 840 und einen Schalttransistor 850 aufweist, der mit einem anderen Ende des Übertragers 270 der Leistungsendstufe 200 verbunden ist. Sowohl die Mikroprozessor gesteuerte Steuereinrichtung 820 als auch die Steuereinrichtung 840 sind Bestandteile einer mehrkanaligen Sicherheitsvorrichtung 810, die weiter unten anhand der Figuren 13 und 14 näher erläutert wird. Angemerkt sei an dieser Stelle, dass anstelle der Steuereinrichtungen 820 und 840 auch die Steuereinrichtungen 770 und 780 der in Fig. 10 dargestellten Sicherheitsvorrichtung 750 verwendet werden können. In diesem Zusammenhang sei noch darauf hin gewiesen, dass die in den Figuren 10 und 13 dargestellte Ausgangsstufe 790 zum Beispiel der in dem Sicherheitsschaltgerät eingesetzten Leistungsendstufe 200 entspricht.

Dem Mikroprozessor 822 der ersten Mikroprozessor gesteuerten Steuereinrichtung 820 ist ein Modulator 824 zugeordnet, dessen Ausgangssignal über einen digitalen Ausgang einer Schnittstelle 940 einer extern an das Sicherheitsschaltgerät 900 angeschlossenen Eingangsstufe 760 zugeführt wird. Man beachte, dass es sich bei dieser Eingangsstufe um die in den Figuren 10 und 13 dargestellte Eingangsstufe 760 der Sicherheitsvorrichtung 750 bzw. 810 handeln kann. Das Ausgangssignal der zweiten Steuereinrichtung 840 wird ebenfalls dem Mikroprozessor 822 zugeführt, der unter Ansprechen auf das empfangene Ausgangssignal die ordnungsgemäße Funktionsweise der zweiten Steuereinrichtung 840 überprüfen kann. Der Mikroprozessor 822 erzeugt in Verbindung mit dem Modulator 824 ein Überwachungssignal, welches signalisiert, ob die beiden Steuereinrichtungen 820 und 840 ordnungsgemäß arbeiten. Um sicherstellen zu können, dass der an das Sicherheitsschaltgerät 900 angeschaltete Drehstrommotor in einen sicheren Zustand gefahren werden kann, wenn entweder Schaltungskomponenten des Sicherheitsschaltgerätes 900, insbesondere die Steuereinrichtungen 820 und 840, defekt sind, oder von extern beispielsweise ein in der Eingangsstufe 760 implementierter Notausschalter 765 betätigt wird, wird sowohl das Eingangssignal des Notauschalters 765 als auch das Ausgangssignal des Modulators 824 einer Verknüpfungseinrichtung 762, welche beispielsweise ein Und-Gatter sein kann, zugeführt. Das Ausgangssignal der Verknüpfungseinrichtung 762 der Eingangsstufe 760 wird über eine Verbindung 63 einem digitalen Eingang einer Schnittstelle 945 des Sicherheitsschaltgerätes 900 zugeführt. Über die Schnittstelle 945 gelangt das Eingangssignal über einer Verbindung 63' zum Demodulator 830 der zweiten Steuereinrichtung 840 und zum Mikroprozessor 822. Erkennt der Demodulator 830 der Steuereinrichtung 840 oder der Mikroprozessor 822 der Steuereinrichtung 820, dass das vom Modulator 824 erzeugte Überwachungssignal einen Systemfehler signalisiert und/oder der Notausschalter 762 betätigt worden ist, so werden die jeweiligen Schalttransitoren 828 und 850 angesteuert, um die Leistungsendstufe 200 aufzutrennen, so dass die Energieversorgung über die Leiter L1, L2 und L3 zu den Ausgangsleitern T1, T2 und T3 und somit zum angeschlossenen Drehstrommotor unterbrochen wird.

An dieser Stelle sei angeführt, dass die in Fig. 1 gezeigte Eingangsstufe 760 lediglich der einfachen Darstellung wegen nur einen Schalter 765 enthält, der einen Notausschalter symbolisiert. Denkbar ist auch, einen Notausschalter mit mehreren Schaltern zu verwenden, wobei die Schalter in diesem Fall jeweils mit einem separaten Ausgang der Schnittstelle 940 und einem separaten Eingang der Schnittstelle 945 verbunden sein können. Ferner ist denkbar, dass die Eingangsstufe 760 alternativ oder zusätzlich zu einem Notausschalters, eine Schutztür, und/oder einen Zweihand-Schalter aufweisen kann. Je nach Ausführungsform werden die jeweiligen Ausgangssignale mit dem Überwachungssignal des Modulators 824 der Mikroprozessor gesteuerten Steuereinrichtung 828 in der Verknüpfungseinrichtung 762 verknüpft, wie dies nachfolgend noch näher erläutert wird.

Dank dieser besonderen Maßnahmen ist das Sicherheitsschaltgerät 900 in der Lage, eine komplexe und vielfältige sicherheitstechnische Überwachung einer an das Sicherheitsschaltgerät 900 angeschalteten sicherheitstechnischen Einrichtung, beispielsweise eines Drehstrommotors zu übernehmen. In einer besonders zweckmäßigen Ausführungsform sind die Anschlußeinrichtungen 910 und 920, die Leistungsendstufe 200, die Bauteile der Steuereinrichtung 820 und 850 sowie die Schnittstellen 940 und 945 auf einer Leiterplatte (nicht dargestellt angeordnet. Demzufolge muß bei der Implementierung einer Anlage mit sicherheitstechnischen Einrichtungen lediglich dafür gesorgt werden, dass die sicherheitstechnische Einrichtung mit dem Sicherheitsschaltgerät 900 verbunden wird. Die Bedienperson muß sich nicht darum kümmern, wie die sicherheitstechnische Einrichtung an die jeweiligen Motorschutzschalter und Schutzrelais und ggfs. an einen Notauschalter angeschlossen werden muß. Die Gefahr von Fehlverdrahtungen ist somit deutlich gegenüber den bekannten Maßnahmen reduziert.

Weiterhin kann die Schnittstelle 945 zwei digitale Eingänge aufweisen, an die zwei Leitungen R und L angeschlossen sind, über die Steuersignale für den Rechts- oder Linkslauf eines Drehstrommotors angelegt werden können. Die Steuersignale werden ebenfalls dem Mikroprozessor 822 zugeführt, der die Leistungsendstufe entsprechend ansteuert. Die einzelnen Verbindungsleitungen sind der besseren Übersichtlichkeit wegen nicht in der Figur 1 dargestellt. Weiterhin weist die Schnittstelle 945 einen weiteren Eingang R1 auf, an den ein nicht dargestellter Reset-Taster angeschlossen werden kann. Beispielsweise kann die Flanke eines angelegten Resetsignals vom Mikroprozessor 822 detektiert werden, der daraufhin die Leistungsendstufe 200 ansteuert, um nach Abschaltung des Drehstrommotors infolge eines Fehlers den Drehstrommotor wieder in Betrieb zu nehmen.

Dreiphasige Leistungsendstufe

Fig. 3 zeigt die dreiphasige Leistungsendstufe mit drei Leitern 210, 211 und 212, die in dem Sicherheitsschaltgerät 900 eingesetzt werden kann. Die zu einer nicht dargestellten Drehstromversorgungseinrichtung weisenden Leiterenden tragen in herkömmlicherweise die Bezeichnungen L1, L2 und L3, während die entfernten Leiterenden die üblichen Bezeichnungen T1, T2 und T3 tragen. In der Nähe der Leiterenden L1, L2 und L3 befindet sich zwischen den drei Leitern 210, 211 und 212 eine an sich bekannte Überspannungsschutzschaltung 220, die ähnlich der in Fig. 2 gezeigten Schutzschaltung 40 aufgebaut sein kann. Zwischen den Leitern 210 und 211 ist ein elektromechanisches Schaltelement 230 geschaltet, welches im vorliegenden Beispiel ein Relais mit zwei Schaltkontakten 231 und 232 ist. Der Schaltkontakt 231 ist in den Leiter 210 geschaltet, während der Schaltkontakt 232 in den Leiter 211 geschaltet ist. Ein zweites elektromechanisches Schaltelement 240, welches im vorliegenden Beispiel wiederum ein Relais ist, ist zwischen dem Leiter 211 und dem Leiter 212 geschaltet. Das Relais 240 weist wiederum zwei Schaltkontakte 241 und 242 auf. Der Schaltkontakt 241 ist in den Leiter 211 geschaltet, während der Schaltkontakt 242 in den Leiter 212 geschaltet ist. Parallel zum Schaltkontakt 241 ist eine allgemein mit 250 bezeichnete Schalteinrichtung geschaltet, die als Halbleiterschaltelement einen Triac, also einen Wechselstromschalter, und eine dazu parallel geschaltete Reihenschaltung aus einem Widerstand 252 und einem Kondensator 253 aufweist, welche als Schutzschaltung für den Triac 251 fungiert. An dieser Stelle sei erwähnt, dass die besondere Schaltungsanordnung der dreiphasigen Leistungsendstufe 200 dazu führt, dass die Schutzschaltung nicht erforderlich ist. Der Grund hierfür wird weiter unten näher ausgeführt.

In ähnlicher Weise ist parallel zum Schaltkontakt 242 eine Schalteinrichtung 260 geschaltet, die ebenfalls einen Halbleiterschalter 261, welcher als Triac ausgebildet ist, aufweist. Ferner ist eine optionale Schutzschaltung parallel zu dem Halbleiterschalter 261 geschaltet. Die Schutzschaltung enthält wiederum beispielsweise einen Kondensator 263 und einen Widerstand 262. Die Zündenergie für die Triacs 251 und 261 wird beispielsweise von einem Übertrager 270 geliefert, der an einer Wechselspannung angeschlossen sein kann. In an sich bekannter Weise kann Die Zündenergie für die Triacs 251 und 261 kann in an sich bekannter Weise auch von einem Opto-Triac bereitgestellt werden. Als Halbleiterschalter 251 und 261 können anstelle von Triacs auch antiparallele Thyristoren verwendet werden.

Bereits an dieser Stelle sei erwähnt, dass ein Vorteil der in Fig. 3 gezeigten dreiphasigen Leistungsendstufe gegenüber der in Fig. 2 gezeigten bekannten Leistungsendstufe darin zu sehen ist, dass als Halbleiterbauelemente für die Halbleiterschalter 251 und 261 kostengünstigere Bauteile verwendet werden können, da die Halbleiterschalter 261 und 251 lediglich einer Sperrspannung von etwa 800 V ausgesetzt werden, während die Halbleiterschalter 60 und 90 Sperrspannungen von etwa 1200 V standhalten müssen. Ein Grund hierfür ist darin zu sehen, dass die Wendeschutzschaltung 100 gemäß der in Fig. 2 gezeigten Leistungsendstufe lediglich die Laufrichtung eines angeschlossenen, nicht dargestellten, Drehstrommotors steuert. Im Unterschied dazu wird in der Leistungsendstufe 200 nach Fig. 3 eine Wendeschalteinrichtung 280 verwendet, die nicht nur die Laufrichtung eines angeschlossenen Drehstrommotors wechseln kann, sondern auch der Abschaltung der Leistungsendstufe dient. Hierzu weist die Wendeschalteinrichtung 280 zwei elektromechanische Schaltelemente 290 und 295 auf, die parallel zwischen die Leiter 210 und 212 geschaltet sind. Beide Schaltelemente sind beispielsweise jeweils als Relais ausgebildet. Das Relais 290 weist zwei Schaltkontakte 291 und 292 auf, wobei der Schaltkontakt 291 an den Leiter 210 und der Schaltkontakt 292 an den Leiter 212 angeschaltet ist. Das Relais 295 weist ebenfalls zwei Schaltkontakte 296 und 297 auf. Der Schaltkontakt 296 ist mit dem Anschluss T1 des Leiters 210 verbunden, während der Schaltkontakt 297 mit dem Anschluss T3 des Leiters 212 verbunden ist. Dadurch, dass die Schaltelemente 290 und 295 zwischen den Leitern 210 und 212 angeordnet sind, können deren Schaltkontakte gegensinnig angesteuert werden, derart, dass die Wendeschaltung 280 in der dargestellten Stellung der Schaltkontakte 291, 292, 296 und 297 die Leiter 210 und 212 auftrennt. Ein Stromfluss durch die Leiter 210 und 212 wird somit mechanisch unterbrochen. Ein Stromfluss vom Leiteranfang L1 zum Leiterausgang T3 beziehungsweise vom Leiteranfang L3 zum Leiterausgang T1 wird dadurch erreicht, dass die Schaltkontakte 296 und 297 des Relais 295 nach innen geschaltet werden und dadurch mit gekreuzten Leiterabschnitten 302 bzw. 303 verbunden werden.

Werden hingegen die Schaltkontakte 291 und 292 des Relais 290 nach außen geschaltet, kontaktieren sie mit den Schaltkontakten 296 und 297 des Relais 295 die Leiterabschnitte 300 bzw. 301. Diese Stellung der Schaltkontakte sorgt für einen Stromfluss durch die Leiter 210 und 212 ermöglicht, sofern der Schaltkontakte 231 sowie der Schaltkontakt 242 geschlossen und/oder der Triac 261 gezündet ist.

Dank des Relais 230, der besonderen Verschaltung der Wendeschalteinrichtung 280 zwischen den Leitern 210 und 212, des Relais 240, welches in die Leiter 211 und 212 geschaltet ist, sowie der Halbleiterschalter 251 und 261, sind die Anforderungen der Sicherheitskategorie 3 für dreiphasige Leistungsendstufen sichergestellt, da ein dreiphasiges Abschalten der Leistungsendstufe 200 möglich ist. Ferner befinden sich beim vorliegenden Ausführungsbeispiel in jedem Leiter zumindest zwei mechanische Schaltkontakte, die sicheres Abschaltung der Leistungsendstufe auch dann erreichen werden, wenn ein Schaltkontakt oder ein Halbleiterschaltelement defekt ist. Da, wie bereits erwähnt, die Wendeschalteinrichtung 280 im Unterschied zu der in Fig. 2 gezeigten Wendeschalteinrichtung 100 eine Abschaltfunktionalität für die Leiter 210 und 212 besitzt, und ferner in dem Leiter 211 ein separater Schaltkontakt 232 angeordnet ist, liegen im abgeschalteten Zustand an den Halbleiterschaltelementen 251 und 261 niedrigere Sperrspannungen an als an den Halbleiterschaltelementen 60 und 90 der in Fig. 2 gezeigten Leistungsendstufe. Damit können kostengünstigere Bauelemente zur Realisierung der Halbleiterschaltelemente verwendet und auf eine Schutzbeschaltung verzichtet werden.

In Fig. 4 ist eine alternative Ausführungsform einer dreiphasigen Leistungsendstufe dargestellt, die allgemein mit 400 bezeichnet ist. Ähnlich der in Fig. 3 gezeigten Leistungsendstufe 200 weist die in Fig. 4 gezeigte Leistungsendstufe wiederum zumindest zwei mechanische Schaltkontakte in jedem Leiter auf. Auch die Leistungsendstufe 400 weist drei Leiter auf, die in Fig. 4 mit 410, 411 und 412 bezeichnet sind. Die Einspeisung der Wechselströme in die Leiter 410, 411 und 412 erfolgt beispielsweise über Übertrager 420, 421 und 422. Eingangsseitig ist ähnlich zu der in Fig. 3 dargestellten Leistungsendstufe 200 eine Überspannungsschutzschaltung 430 zwischen den Leitern 410, 411 und 412 angeschaltet. Ähnlich der in Fig. 3 gezeigten Leistungsendstufe 200 ist zwischen den Leiter 411 und 412 ein elektromechanisches Schaltelement in Form eines Relais 430 geschaltet, welches zwei Schaltkontakte 431 und 432 aufweist. Der Schaltkontakt 431 befindet sich im Leiter 411, während der zweite Schaltkontakt 432 sich im Leiter 412 befindet. Parallel zum Schaltkontakt 431 ist eine Schalteinrichtung 440 geschaltet, die ähnlich der in Fig. 3 dargestellten Schalteinrichtung 250 ein Halbleiterschaltelement, welches ein Triac sein kann, und optional eine Schutzschaltung aufweisen kann. In ähnlicher Weise parallel zum Schaltkontakt 432 eine Schalteinrichtung 445 geschaltet, die wiederum einen als Triac ausgebildeten Halbleiterschalter und optional dazu eine Schutzeinrichtung aufweisen kann. Im Unterschied zu der in Fig. 3 gezeigten Leistungsendstufe 200 ist in den Leiter 410 ein Relais 450 mit beispielsweise zwei Schaltkontakten 451 und 452 geschaltet. Im Unterschied zur Leistungsendstufe 200 nach Fig. 3 ist eine Wendeschalteinrichtung 460 nicht zwischen den ersten und dritten Leiter sondern zwischen den zweiten Leiter 411 und den dritten Leiter 412 geschaltet. Die Wendeschalteinrichtung 460 weist ähnlich der in Fig. 3 gezeigten Wendeschalteinrichtung 280 zwei elektromechanische Schaltelemente 470 und 475 in Form von Relais auf. Das Relais 470 weist wiederum zwei Schaltkontakte 471 und 472 auf, wobei der Schaltkontakt 471 mit dem Leiter 411 verbunden ist, während der Schaltkontakt 472 mit dem Leiter 412 verbunden ist. In ähnlicher Weise weist das Relais 475 zwei Schaltkontakte 476 und 477 auf.

Der Schaltkontakt 476 ist mit dem Leiter 411 verbunden, während der Schaltkontakt 477 mit dem Leiter 412 verbunden ist. Die Wendeschalteinrichtung 460 weist weiterhin Leiterabschnitte 480, 481, 482 und 483 auf, an die die Schaltkontakte der Relais 470 und 475 angelegt werden können, um einen Wechsel des Stromflusses vom Leiter 411 zum Leiter 412 und umgekehrt, einen Durchfluss des Stroms durch die Leiter 411 und 412 sowie eine Sperrung des Stromflusses durch die Leiter 411 und 412 zu ermöglichen. Diese Funktionsweise wurde bereits an Hand der Leistungsendstufe 200 ausführlich erläutert. Die Schaltkontakte 471 und 472 des Relais 470 sowie die Schaltkontakte 476 und 477 des Relais 475 können wiederum gegensinnig angesteuert werden können, so dass mit der in Fig. 4 gezeigten Stellung der Schaltkontakte die Wendeschalteinrichtung 460 den Stromfluss durch die Leiter 411 und 412 mechanisch unterbrechen kann. Ausgangsseitig kann an die Leiter 410, 411 und 412 ein Spannungsdetektor 490 angeschlossen sein, über den die Ausgangsspannungen an den Leitern 410, 411 und 412 gemessen werden können. Hierzu bilden Widerstände 491 und 494 einen Spannungsteiler, der an den Leiter 410 angeschlossen ist, Widerstände 492 und 495 einen Spannungsteiler, der an den Leiter 411 angeschlossen ist, und Widerstände 493 und 496 einen Spannungsteiler, der an den Leiter 412 angeschlossen ist. In die Leiter 410, 411 und 412 kann jeweils ein Stromdetektor (nicht dargestellt) geschaltet sein, der den Strom in den jeweiligen Leitern messen kann. Die gemessenen Spannungs- und Stromwerte können einer Ablaufsteuerungs- und Überwachungseinrichtung 405 zugeführt werden. Ferner ist die Ablaufsteuerungs- und/oder Überwachungseinrichtung 405 mit den Schaltkontakten 431, 432, 451, 452, 471, 476, 472, 477 und den Halbleiterschaltern 440 und 445 verbunden. Die Schaltkontakte und Halbleiterschalter können gemäß einer programmierbaren Ablaufsteuerung oder unter Ansprechen auf einen gemessenen Spannungs- und/oder Stromwert, der einen Fehler der Leistungsendstufe 400 anzeigt, angesteuert werden. Ebenfalls kann die Ablaufsteuerungs- und/oder Überwachungseinrichtung 405 die Laufrichtung eines angeschlossenen Drehstrommotors überwachen.

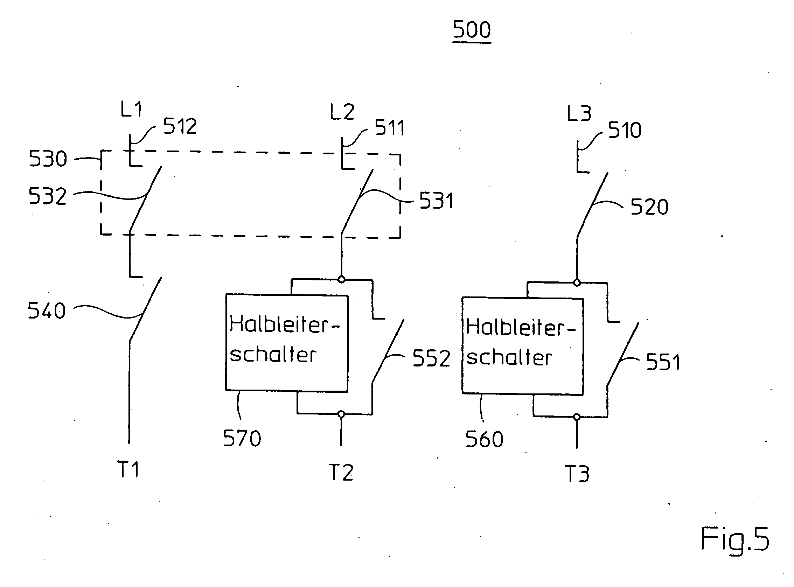

Für den Fall, dass ein angeschlossener Drehstrommotor nur in einer Laufrichtung betrieben werden soll, kann auf eine Wendeschalteinrichtung verzichtet werden. Eine entsprechende Leistungsendstufe ist in Fig. 5 schematisch dargestellt. Die dreiphasige Leistungsendstufe 500 weist wiederum drei Leiter 510, 511 und 512 auf. Damit auch die Leistungsendstufe 500 die Anforderungen der Sicherheitskategorie 3 erfüllen kann, ist in jeden Leiter wenigstens ein Schaltkontakt 520, 531 und 532 geschaltet. Um ein gesichertes dreiphasiges Abschalten der Leistungsendstufe 500 ermöglichen zu können, können wenigstens zwei Kontakte unabhängig voneinander angesteuert werden. Im vorliegenden Beispiel sind die Schaltkontakte 531 und 532 Teil eines elektromechanischen Schaltelementes 530, welches an die Leiter 511 und 512 angeschlossen ist. Der mit dem Leiter 510 verbundene Schaltkontakt 520 ist Bestandteil eines separaten Schaltelementes. Demzufolge kann der Schaltkontakt 520 gesondert und unabhängig von den Schaltkontakten 531 und 532 angesteuert werden. Um ein sicheres dreiphasiges Abschalten der Leistungsendstufe 500 auch bei Ausfall eines Schaltkontaktes gewährleisten zu können, sind in jedem Leiter zwei Schaltstufen vorgesehen. Die erste Schaltstufe enthält die Schaltkontakte 520, 531 und 532. Die zweite Schaltstufe weist einen Schaltkontakt 540 im Leiter 512, einen Schaltkontakte 551 im Leiter 510 und einen Schaltkontakt 552 im Leiter 511 auf. Parallel zu den Schaltkontakten 551 und 552 können Halbleiterschalter 560 und 570 geschaltet sein, die vorzugsweise wieder aus Triacs aufgebaut sind. Zweckmäßigerweise gehören die Schaltkontakte 551 und 552 zu einem Relais.

Die in den Figuren 3, 4 und 5 dargestellten Leistungsendstufen zeichnen sich dank der Verwendung elektromechanischer Schaltelemente durch eine große Robustheit gegen Störungen und durch geringe thermische und elektrische Verluste der Halbleiterschalter aus.

Nachfolgend wird die Funktionsweise der dreiphasigen Leistungsendstufe in Verbindung mit der in Fig. 4 dargestellten Ausführungsvariante näher erläutert.

Zunächst wird die Einschaltphase der Leistungsendstufe beschrieben. Im ersten Schritt werden über die Ablaufsteuerungs- und Überwachungseinrichtung 405 die beiden Schaltkontakte 451 und 452 des Relais 450 geschlossen. Demzufolge besteht ein geschlossener Strompfad über den Leiter 410. Je nachdem, in welcher Laufrichtung ein angeschalteter Drehstrommotor betrieben werden soll, werden entweder die Schaltkontakte 471 und 472 des Relais 470 eingeschaltet, um einen Linkslauf zu erreichen, oder die Schaltkontakte 476 und 477 des Relais 475 geschaltet, um einen Rechtslauf des Drehstrommotors zu erreichen. Werden die Schaltkontakt 471 und 472 nach innen geschaltet, so wird der in den Leiter 411 eingespeiste Wechselstrom über den Schaltkontakt 471 den Leiterabschnitt 481, den Schaltkontakt 477 zum Leiteranschluss T3 des Leiters 412 geführt, während ein in den Leiter 412 eingespeister Wechselstrom über den Schaltkontakt 472, den Leiterabschnitt 482 über den Schaltkontakt 476 zum Leiteranschluss T2 des Leiters 411 geführt wird. Werden hingegen die Schaltkontakte 476 und 475 angesteuert, so findet kein Stromwechsel zwischen den Leitern 411 und 412 statt.

Nach etwa 20 ms werden die Halbleiterschalter 440 und 445 über eine nicht dargestellte Energieversorgungseinrichtung gezündet. Beispielsweise können die Halbleiterschalter 440 und 445 über den in Fig. 3 dargestellten Übertrager 270 mit Zündenergie versorgt werden. Nach weiteren 20 ms werden die Schaltkontakte 431 und 432 des Relais 430 geschlossen. Es sei darauf hingewiesen, dass die angegebenen Zeitspannen lediglich beispielhaft zu verstehen sind. Vorzugsweise sind die Zeitdauern sogar kürzer. Ebenfalls ist es denkbar, die Schaltkontakte 431 und 432 gleichzeitig mit der Zündung der Triacs 440 und 445 zu schließen.

Für den vorliegenden Fall sei angenommen, dass die Schaltkontakte 476 und 477 des Relais 475 nach außen geschaltet worden sind, so dass nunmehr durchgeschaltete Leiter 411 und 412 vorliegen. Nachdem die Schaltkontakt 431 und 432 geschlossen worden sind, kann die Zündenergie von den Halbleiterschaltelementen 440 und 445 wieder abgeschaltet werden. Da die Halbleiterschalter 440 und 445 nur noch für eine kurze Zeitspanne, vorzugsweise weniger als 20 ms einen einfachen Wechselstrom schalten müssen, können entsprechend kostengünstige Halbleiter zur Realisierung der Triacs verwendet werden. Aus diesem Grund kann auch eine Schutzbeschaltung der Triacs 440 und 445 entfallen.

Nunmehr wird das ordnungsgemäße Abschalten der Leistungsendstufe 400 beschrieben. Zunächst werden die Halbleiterschalter 440 und 445 wieder gezündet und anschließend die Schaltkontakte 431 und 432 des Relais 430 geöffnet. Der Stromfluss erfolgt nunmehr kurzfristig, in der Regel für weniger als 20 ms, über die Halbleiterschaltelemente 440 und 445. Nach etwa 20 ms wird die Zündenergie von den Halbleiterschaltern 440 und 445 abgetrennt, wodurch der Antrieb eines angeschlossenen Drehstrommotors abgeschaltet wird. Nach weiteren beispielsweise 20 ms werden die Schaltkontakte 451 und 452 geöffnet und die Schaltkontakte 476 und 477 der Wendeschaltung 460 wieder nach innen geschaltet, so dass sie nunmehr wieder mit einem Ende des Leiterabschnitts 482 beziehungsweise 481 verbunden sind. Die Wendeschalteinrichtung 460 befindet sich demzufolge wieder im Sperrzustand.. Alle drei Leiter der dreiphasigen Leistungsendstufe 400 sind nunmehr geöffnet und ein sicherer Abschaltzustand ist erreicht.

Während des Betriebs werden die Ströme in den Leitern 410, 411 und 412 sowie die an den Leitern anliegenden Ausgangsspannungen von der Ablaufsteuerungs- und Überwachungseinrichtung überwacht. Sobald die Ablaufsteuerungs- und Überwachungseinrichtung 405 einen Störfall erkennt, werden beispielsweise die Schaltkontakte 451 und 452 im Leiter 410 sowie beispielsweise die Schaltkontakte 476 und 475 und die Schaltkontakte 471 und 471 in den in Fig. 3 gezeigten Schaltzustand versetzt, so dass eine dreiphasige mechanische Abschaltung sicher erfolgen kann.

Die Funktionsweise und Ansteuerung der Schaltkontakte der in Fig. 3 gezeigten dreiphasigen Leistungsendstufe 200 entspricht im Wesentlichen der Funktionsweise und Schaltweise der in Fig. 4 dargestellten und oben beschriebenen Leistungsendstufe 400. Die in Fig. 3 gezeigte Leistungsendstufe zeichnet sich gegenüber der in Fig. 4 gezeigten Leistungsendstufe 400 dadurch aus, dass auch bei Weglassen des Relais 230 eine dreiphasige Abschaltung der Leistungsendstufe erfolgen kann, da in jedem Leiter wenigstens ein Schalter in Form eines mechanischen Schaltkontaktes oder eines Halbleiterschalters vorgesehen ist.

Messvorrichtung

Fig. 6 zeigt das beispielhafte Messgerät 610, welches beispielsweise zur Messung sinusförmiger Ströme geeignet ist. Das Messgerät 610 dient nicht nur dazu, Nennströme, d. h. Ströme innerhalb eines vorbestimmten und zulässigen Arbeitsbereichs zu messen. Es dient auch dazu, bei Auftreten eines Überstroms, der außerhalb des zulässigen Arbeitsbereichs des Messgerätes 610 liegt, einen Wert für den tatsächlichen Spitzenwert des Überstroms zu ermitteln. Das Messgerät 610 und dessen Komponenten, insbesondere ein Stromwandler, können deshalb hinsichtlich des maximalen Nennstroms eines Motors dimensioniert sein und somit erheblich kleiner und kostengünstiger hergestellt werden, als Messgeräte, die auch Überströme, die das Siebenfache des Motornennstroms betragen können, messen können.

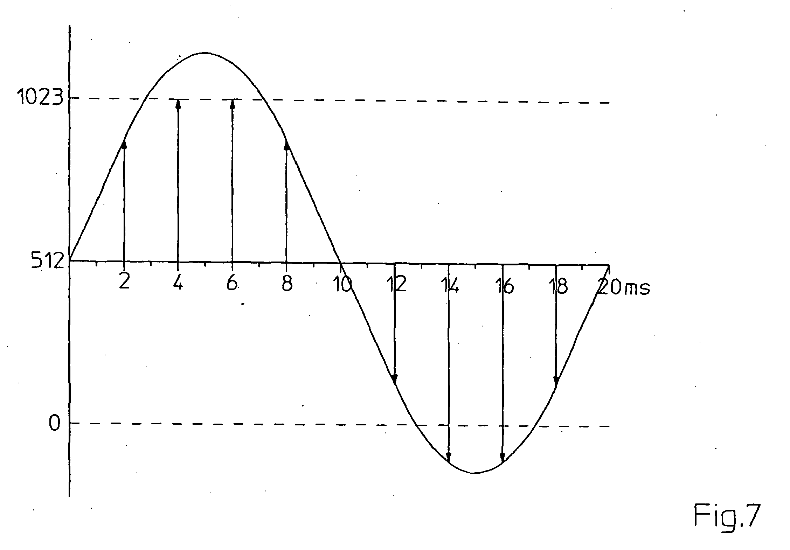

Hierzu kann das Messgerät 610 eingangsseitig ein Abtast- und Halteglied 620 aufweisen, an welches das beispielsweise vom Leiter L1 des Sicherheitsschaltgerätes 900 abgezweigte, zu messende periodische Analogsignal angelegt werden kann. Das Abtast- und Halteglied 620 tastet ein zu messendes Analogsignal mit einer vorbestimmten Abtastfrequenz ab, welche einstellbar sein kann. Der Ausgang des Abtast- und Halteglieds 620, an dem analoge Abtastproben des zu messenden Analogsignals anliegen, werden einem AD-Umsetzer 630 zugeführt, welcher die Abtastproben in die dazu gehörenden Digitalwörter umsetzt. Zum Beispiel kann der AD-Umsetzer 630 aus den angelegten Abtastwerten Digitalwerte mit der Länge von 610 Bits erzeugen. Bei einem solchen 10 Bit AD-Umsetzer werden die analogen Abtastproben jeweils in eine Folge von 10 Bits umgesetzt, die wiederum in die entsprechende Dezimalzahl, die zwischen zwischen 0 und 1023 liegt, umgewandelt werden kann. Hierbei entspricht zum Beispiel der dezimale Wert 0 dem kleinsten und der dezimale Zahlenwert 1023 dem größten Stromwert innerhalb des zulässigen Arbeitsbereichs, sofern die Nulllinie eines sinusförmigen Signals dem dezimalen Zahlenwert 512 zugeordnet wird. Ein solcher Fall ist in Fig. 7 dargestellt.

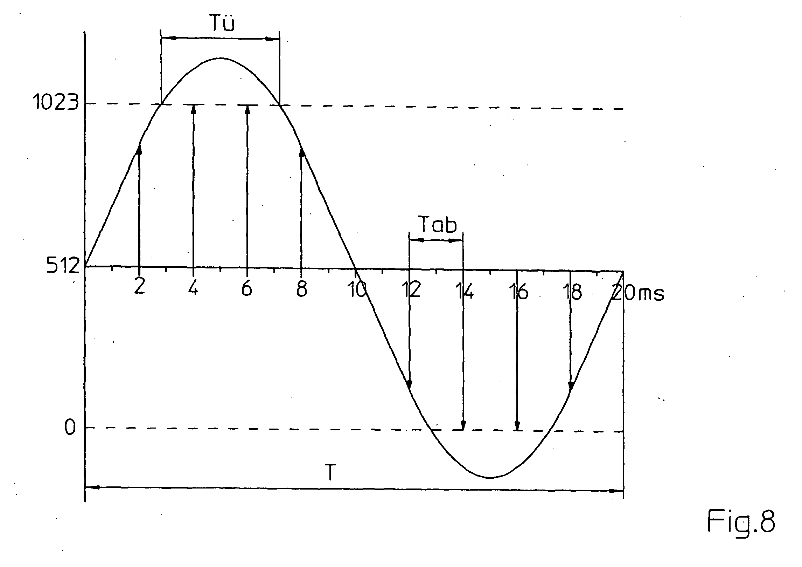

Der Ausgang des AD-Umsetzers 630 ist mit dem Eingang eines Vergleichers 640 verbunden, in dem beispielsweise die im AD-Umsetzer 630 gebildeten dezimalen Zahlenwerte der Abtastproben eines Messsignals mit einem Schwellenwert verglichen werden. Im vorliegenden Beispiel sei angenommen, dass der Schwellenwert mit dem oberen und/oder unteren Grenzwert des zulässigen Arbeitsbereichs des Messgeräts 610, d. h. dem dezimalen Wert 1023 und/oder dem dezimalen Wert 0 zusammenfällt, wie dies in den Fig. 7 und 8 durch die gestrichelten Linien dargestellt ist. Der Ausgang des Vergleichers 40 ist mit einem Zähler 650 verbunden, der zählt, wie viele aufeinander folgende Zahlenwerte dem Schwellenwert 1023 und/oder 0 entsprechen. Eine Auswerteeinrichtung 660 ist mit dem Ausgang des Zählers 650 verbunden. Wie später noch ausführlicher dargelegt wird, dient die Auswerteeinrichtung 660 dazu, den maximalen Amplitudenwert, d. h. den Spitzenwert des zu messenden Analogsignals, welches sich außerhalb des Arbeitsbereichs des Messgeräts 610 befindet, zu ermitteln.

Gemäß einer alternativen Ausführungsform sind die entsprechenden, zur Ermittlung der maximalen Amplitude erforderlichen Werte vorab in einem Tabellenspeicher 670 abgelegt worden, auf den die Auswerteeinrichtung 660 zugreifen kann.

Nachfolgend wird die Funktionsweise des in Fig. 6 dargestellten Messgeräts 610 anhand von zwei Ausführungsbeispielen näher erläutert.

Zunächst betrachten wir Fig. 7. In Fig. 7 ist ein zu messender Wechselstrom mit einer Periodendauer von 20 ms dargestellt, der im Abtast- und Halteglied 620 mit einer Abtastfrequenz von 50 kHz (f=1/2ms) abgetastet wird. Die Abtastproben sind als Pfeile im Abstand von 2ms in der Fig. 7 dargestellt. Es ist zu beachten, dass der Messstrom sich innerhalb des zulässigen Messbereichs des Messgeräts 610 befindet. Die zulässige Ober- und Untergrenze des Mess- oder Arbeitsbereichs sind gestrichelt dargestellt und den beiden Dezimalwerten 0 und 1023 zugeordnet. So lange das zu messende Signal innerhalb dieses Messbereichs liegt, arbeitet das Messgerät 610 in dem herkömmlichen Messmodus.

Überschreitet, wie in Fig. 8 dargestellt, das Messsignal den zulässigen Messbereich, so kann der AD-Umsetzer 630, der nur für den zulässigen Arbeitsbereich dimensioniert ist, das Signal nicht mehr korrekt auflösen und geht in die Sättigung. Dies führt dazu, dass die Abtastproben, die außerhalb des zulässigen Messbereichs liegen, allesamt durch den maximalen und minimalen Zahlenwert, d. h. 1023 bzw. 0, dargestellt werden. In diesem Moment geht das Messgerät 610 in seinen zweiten Modus, in dem der Spitzenwert des außerhalb des zulässigen Arbeitsbereichs liegenden Messstroms ermittelt wird. Nachfolgend werden zwei Ausführungsvarianten zur Ermittlung des Spitzenwertes beschrieben.

Bei dem Messsignal handelt es sich um eine sinusförmige Eingangsgröße, die bekanntlich durch die Gleichung

$$i(t) = I * \sin(\omega t) \qquad\qquad (1)$$

beschrieben werden kann, wobei I die Amplitude des Messsignals ist. Die Amplitude ergibt sich demnach durch die Gleichung

$$I = \frac{i(t)}{\sin(\omega t)} \quad . \tag{2}$$

Sind die Periodendauer des Messsignals und die Zeitdauer $T_{\ddot{u}}$, die nachfolgend auch Überstromdauer genannt wird und angibt, wie lange das Messignal den zulässigen Messbereich überschreitet, bekannt, kann die maximale Amplitude durch die Gleichung

$$I = \frac{1}{\sin\left(\pi\left(\frac{1}{2} - \frac{T_{\ddot{u}} * N}{T}\right)\right)} \tag{3}$$

berechnet werden, wobei
$i(t) = 1$ für den Nennbereich gilt,
$\omega = 2\pi/T$, und $T$ die Periodendauer des Messignals ist,
$t = T/4$ $T_{\ddot{u}}/2$, und $T_{\ddot{u}}$ die Überstromdauer ist.
Die sogenannte Überstromdauer $T_{\ddot{u}}$ kann jedoch nicht unmittelbar gemessen werden.
Sie kann jedoch beispielsweise aus der Anzahl der Abtastwerte, die betragsmäßig größer oder gleich einem vorgegebenen Schwellenwert sind, berechnet werden. Im vorliegenden Beispiel sei angenommen, dass der Schwellenwert mit dem Zahlenwert 1023, der den oberen Grenzwert des zulässigen Messbereichs darstellt, übereinstimmt. Ist ferner die Abtastfrequenz $1/T_{ab}$ des Abtast- und Halteglieds 620 bekannt, kann die Überstromdauer $T_{\ddot{u}}$ durch die Gleichung

$$T_{\ddot{u}} \quad = \quad N \; * \; T_{AB} \tag{4}$$

berechnet werden. Je genauer die Überstromzeit $T_{\ddot{u}}$ bestimmt werden kann, d. h. je kleiner das Abtastintervall $T_{AB}$ ist, desto genauer kann die maximale Überstromamplitude I berechnet werden.
Wird Gleichung (4) in Gleichung (3) eingesetzt, so ergibt sich die Berechnungsvorschrift

$$I = \frac{1}{\sin\left(\pi\left(\frac{1}{2} - \frac{T_{AB} * N}{T}\right)\right)} \quad , \tag{5}$$

mit der die Auswerteeinrichtung 660 die maximale Überstromamplitude I des Messignals berechnen kann.
Wir kehren zur weiteren Erläuterung der Funktionsweise des Messgeräts 610 zu Fig. 8 zurück.
Deutlich sichtbar überschreitet die tatsächliche Amplitude des an den Eingang des Messgeräts 610 angelegten Messstroms den oberen und unteren Grenzwert des zulässigen Messbereichs für die Überstromdauer $T_{\ddot{u}}$. Der obere Grenzwert 1023 entspricht in diesem Beispiel auch dem Schwellenwert, der vom Vergleicher 640 benötigt wird, um die Abtastwerte zu ermitteln, die außerhalb des zulässigen Messbereichs liegen.
In Fig. 8 ist sowohl die Periodendauer T des zu messenden sinusförmigen Signals, welche 20 ms beträgt, als auch die zeitliche Dauer $T_{AB}$ zwischen zwei aufeinander folgenden Abtastwerten, welche 2 ms beträgt, dargestellt. Bei dem in Fig. 8 dargestellten Kurvenverlauf ergibt sich, dass der der AD-Umsetzer 30 infolge einer Übersteuerung dem zweiten und dritten Abtastwert den maximalen Zahlenwert 1023 zuordnet. Die den Abtastwerten zugeordneten Zahlenwerte werden dem Vergleicher 640 zugeführt, der die Zahlenwerte mit dem Schwellenwert 1023 vergleicht. Der Vergleicher 640 stellt fest, dass zwei aufeinander folgende Abtastwerte, die nach 4 ms und 6 ms abgetastet worden sind, den maximalen Zahlenwert 1023 angenommen haben. Der Vergleicher 640 triggt daraufhin zweimal den Zähler 650, der daraufhin einen Zählwert 2 an die Auswerteeinrichtung 660 weitergibt. Da die Auswerteeinrichtung 660 die Abtastfrequenz des AD-Umsetzers 630, nämlich $1/T_{AB}$, den vom Zähler gelieferten Zahlwert N = 2 sowie die Periodendauer T des zu messenden Signals, kann sie den maximalen Amplitudenwert des zu messenden Signals gemäß Gleichung (5) berechnen.

Um den schaltungstechnischen Aufwand der Auswerteeinrichtung 660 und deren Rechenleistung reduzieren zu können, werden im Speicher 670 für mehrere Referenzsignale jeweils die ermittelte Anzahl von gezählten Abtastwerten und die dazu gehörenden maximalen Amplitudenwerte gespeichert.

Die im Speicher 670 abgelegten Werte werden vorab ermittelt, indem beispielsweise mehrere Referenzsignale, die die gleiche bekannte Frequenz besitzen, mit einer festen Abtastfrequenz abgetastet. Dann werden für jedes Referenzsignal die Anzahl an Abtastwerten ermittelt, die in den Schwellenwert 1023 umgesetzt worden sind. Mit Hilfe der Gleichung (5) wird schließlich für jedes Referenzsignal der maximale Amplitudenwert ermittelt und zusammen mit der dazu gehörenden Anzahl N in dem Speicher 670 abgelegt.

In der anliegenden Tabelle sind beispielhaft die entsprechenden Werte für Referenzsignale mit einer Frequenz von 50 Hz eingetragen, wobei die Referenzsignale mit einer Abtastfrequenz von 6,66 kHz abgetastet worden sind.

In der linken Spalte, die mit N/2 bezeichnet ist, ist die halbe Anzahl der Messwerte, welche den zulässigen Messbereich überschritten haben, eingetragen. In der mittleren Spalte, die mit I[A] gekennzeichnet ist, ist der jeweilige, gemäß Gleichung (5) berechnete maximale Amplitudenwert eingetragen. In der rechten Spalte der Tabelle ist der maximale Fehler in Prozent eingetragen, der zwischen gemessenem Amplitudenwert und tatsächlichem Amplitudenwert besteht.

Das negative Vorzeichen gibt an, dass der tatsächliche maximale Amplitudenwert des zu messenden Signals immer kleiner als der gemäß Gleichung (5) berechnete maximale Amplitudenwert ist.

Diese Tatsache ist bei elektrischen Antrieben von Vorteil, die bei Überschreiten des zulässigen Nennstroms um einen vorbestimmten Betrag sicher in den Stillstand gefahren werden müssen.

Erwähnt sei an dieser Stelle, dass die in der Tabelle gezeigten Werte bis N/2 = 30 von praktischer Bedeutung sind, da z. B. Asynchronmotoren grundsätzlich nur das Siebenfache ihres Nennstroms aufnehmen können. Dies bedeutet, dass, wenn der Zähler 650 mehr als 62 aufeinander folgende Abtastwerte mit dem Zahlenwert 1023 gezählt hat, der überwachte Asynchronmotor abgeschaltet wird, da der vom Messgerät 610 ermittelte maximale Amplitudenwert von 9, 1129 mehr als dem siebenfachen Nennwert des Asynchronmotors entspricht. Angemerkt sei, dass ein Strom, der dem siebenfachen Nennwert entspricht, auf einen Kurzschluss im Motor hinweist.

Dank der Erfindung ist es möglich, die Amplitude eines Wechselsignals, dessen Kurvenform bekannt ist, außerhalb des zulässigen Arbeitsbereichs mit Hilfe eines Messgeräts abzuschätzen, welches nur zur Messung von Signalen innerhalb des zulässigen Messbereichs dimensioniert ist.

Tabelle

| N/2 | I[A] | max. Fehler (%) |
|-----|------|-----------------|
| 0 | < 1,0000 | Nennbereich |
| 1 | 1,0011 | -0,1110 |
| 2 | 1,0045 | -0,1110 |
| 3 | 1,0101 | -0,3331 |
| 4 | 1,0180 | -0,5562 |
| 5 | 1,0284 | -0,7814 |
| 6 | 1,0413 | -1,0096 |
| 7 | 1,0570 | -1,2419 |
| 8 | 1,0755 | -1,4795 |
| 9 | 1,0972 | -1,7238 |
| 10 | 1,1223 | -1,9760 |
| 11 | 1,1512 | -2,2379 |
| 12 | 1,1844 | -2,5112 |
| 13 | 1,2223 | -2,7979 |
| 14 | 1,2656 | -3,1004 |
| 15 | 1,3151 | -3,4217 |

(fortgesetzt)

| N/2 | I[A] | max. Fehler (%) |
|-----|------|-----------------|
| 16 | 1,3718 | -3, 7649 |
| 17 | 1,4370 | -4,1342 |
| 18 | 1,5121 | -4,5346 |
| 19 | 1,5994 | -4,9720 |
| 20 | 1,7013 | -5,4541 |
| 21 | 1,8214 | -5,9908 |
| 22 | 1,9645 | -6,5946 |
| 23 | 2,1371 | -7,2822 |
| 24 | 2,3486 | -8,0762 |
| 25 | 2,6131 | -9,0078 |
| 26 | 2,9521 | -10,1216 |
| 27 | 3,4009 | -11,4835 |
| 28 | 4,0211 | -13,1953 |
| 29 | 4,9313 | -15,4232 |
| 30 | 6,3925 | -18,4577 |
| 31 | 9,1129 | -22,8578 |

Sicherheitsvorrichtung

Fig. 9 zeigt schematisch den Aufbau eines bekannten Systems zur mikroprozessorgesteuerten Überwachung einer sicherheitstechnischen Einrichtung (nicht dargestellt). Das System weist eine Eingangsstufe 710 auf, die ein binäres Prozess- oder Sensorsignal als Eingangssignal an zwei unabhängig voneinander arbeitende Subsysteme 720 und 730 anlegt. Jedes Subsystem kann einen Mikroprozessor und eine separate Stromversorgungseinrichtung aufweisen. Jedes Subsystem ist ausgangsseitig mit einer Ausgangsstufe 740 verbunden, die beispielsweise einen Schütz oder eine Anordnung aus Schalteinrichtungen aufweist. Mittels der Ausgangsstufe 740 kann eine nicht näher dargestellte sicherheitstechnische Anwendung in einen definierten gesicherten Zustand gefahren werden. Wie in Fig. 9 angedeutet, sind beide Subsysteme 720 und 730 derart ausgebildet, dass sie die Funktionsfähigkeit des jeweils anderen Subsystems überwachen können. Die gegenseitige Überwachung der Subsysteme erfolgt in der Regel durch einen bidirektionalen Austausch von Statusdaten, wie dies durch die Pfeile in Fig. 9 angedeutet ist. Jedes Subsystem bildet einen eigenen Steuerkanal, über den die Ausgangsstufe 740 separat angesteuert werden kann. Demzufolge kann jeder Kanal, das heißt jedes Subsystem die Ausgangsstufe 740 unabhängig von dem anderen Subsystem in einen als sicher definierten Zustand versetzen.

Die beispielhafte mehrkanalige Sicherheitsvorrichtung zur Steuerung von sicherheitstechnischen Einrichtungen ist in Fig. 10 dargestellt. Bereits an dieser Stelle sei darauf hingewiesen, dass unter sicherheitstechnischer Einrichtung eine Automatisierungsanlage, einzelne Baugruppen der Automatisierungsanlage und/oder auch sicherheitstechnische Anwendungen in Form von Software verstanden werden kann.

Ähnlich der in Fig. 9 gezeigten Anordnung weist die in Fig. 10 dargestellte Sicherheitsvorrichtung 750 eine Eingangsstufe 60, eine erste, mikroprozessorgesteuerte Steuereinrichtung 770 und eine zweite Steuereinrichtung 780 auf. Der Ausgang der beiden Steuereinrichtungen 770 und 780 ist jeweils mit einem Eingang einer Ausgangsstufe 790 verbunden. Die Ausgangsstufe 790 weist beispielsweise ein Relais 795 auf.

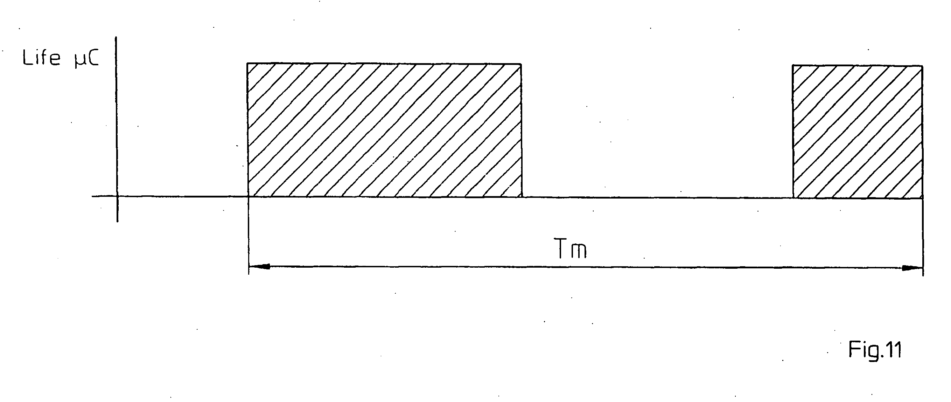

Von einer mehrkanaligen Steuervorrichtung 750 spricht man, da die erste, mikroprozessorgesteuerte Steuereinrichtung 770 und die zweite Steuereinrichtung 780 jeweils einen eigenen Steuerkanal zum unabhängigen Steuern des Relais 795 bilden. Die erste, mikroprozessorgesteuerte Steuereinrichtung 770 enthält einen speicherprogrammierten Mikroprozessor 772 und einen Speicher 774, in dem die Steuersoftware abgelegt ist, auf die der Mikroprozessor 772 zugreifen kann. Ferner enthält die mikroprozessorgesteuerte Steuereinrichtung 770 einen beispielsweise als NPN-Bipolartransistor ausgebildeten Schalter 776, nachfolgend auch Schalttransistor genannt, über den das Relais 795 mit einem Masseanschluss 778 verbunden werden kann. Über den Masseanschluss 778, den Schalttransistor 776 und eine Verbindungsleitung 800, die den Ausgang der mikroprozessorgesteuerten Steuereinrichtung 770 mit dem Eingang der Ausgangsstufe 790 und somit mit dem Eingang des Relais 795 verbindet, wird ein Massepfad definiert. Je nach Betriebszustand kann der Mikroprozessor 772 über den Schalttransistor 776 den Massepfad öffnen oder schließen. Der Mikroprozessor 772 ist derart ausgebildet, dass er ein Überwachungssignal, im nachfolgenden auch Life- Signal genannt, erzeugen kann, dessen zeitlicher Verlauf in Fig. 11 dargestellt ist.

Der Mikroprozessor 772 führt vorzugsweise mit dem von der Eingangsstufe gelieferten Signal sicherheitsrelevante Programme durch, damit bei Auftritt eines Fehlers die sicherheitstechnische Einrichtung über die Ausgangsstufe 790 zuverlässig in einen gesicherten Zustand gefahren werden kann. Als Fehlerquelle können zum Beispiel der Mikroprozessor 772 selbst, die Eingangsstufe 760 oder die sicherheitstechnische Einrichtung in Frage kommen. Das vom Mikroprozessor 772 erzeugte Überwachungssignal spiegelt den ordnungsgemäßen oder fehlerhaften Betrieb der mikroprozessorgesteuerten Steuereinrichtung 770 wieder.

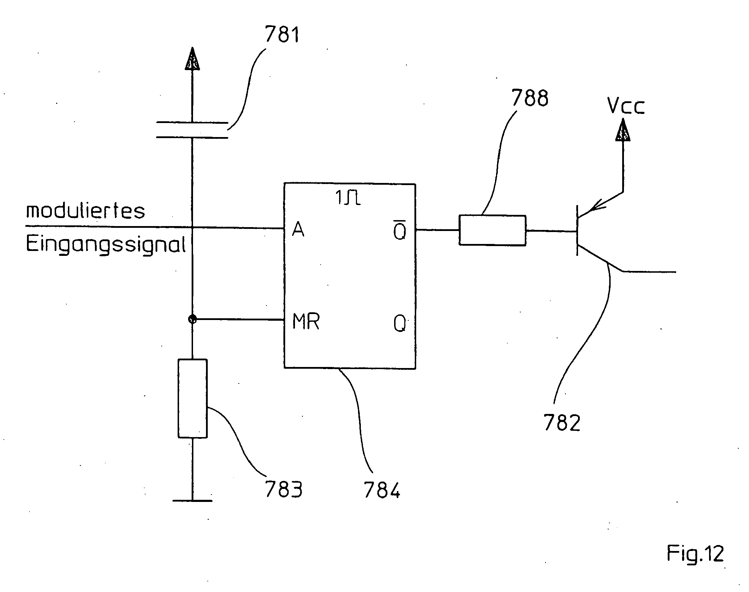

Das Überwachungssignal wird beispielsweise dadurch erzeugt, dass der Mikroprozessor 772 einen High-Pegel erzeugt, wenn der Mikroprozessor mit der Durchführung eines sicherheitsrelevanten Programmes beginnt. Sobald der Mikroprozessor 772 die Ausführung des sicherheitsrelevanten Programms beendet, erzeugt er einen Low- Pegel. In Fig. 11 ist der Verlauf des Überwachungssignals im fehlerfreien Zustand der Steuereinrichtung 770 dargestellt. Die in Fig. 11 eingezeichnete Periodendauer $T_m$ entspricht beispielsweise der Zeitdauer einer in der Steuereinrichtung 780 implementierten monostabilen Kippstufe, nach deren Ablauf die Kippstufe wieder in ihren stabilen Zustand kippt. Eine solche monostabile Kippstufe ist als Monoflop 784 in Fig. 12 dargestellt. Die Zeitdauer $T_m$ wird nachfolgend auch als Monozeit bezeichnet. Die Funktionsweise der Steuereinrichtung 800 wird weiter unten noch näher erläutert.

Das vom Mikroprozessor 772 erzeugte Life-Signal wird über einen Ausgang der mikroprozessorgesteuerten Steuereinrichtung 770 an einen Eingang der Eingangsstufe 760 angelegt. An einem weiteren Eingang der Eingangsstufe 760 liegt das binäre Prozesssignal an. Das Prozessignal und das Life-Signal werden beispielsweise eingangsseitig einem UND-Gatter 762 zugeführt. Das UND-Gatter 762 verknüpft oder moduliert beide Signale und liefert an seinem Ausgang ein sogenanntes moduliertes Eingangssignal für die Steuereinrichtungen 770 und 780. Alternativ kann an Stelle eines logischen UND-Gatters jede andere geeignete logische Verknüpfungseinrichtung oder ein mechanischer Schalter als Modulationseinrichtung verwendet werden. Entscheidend ist, dass bei der in Fig. 10 dargestellten Sicherheitsvorrichtung 750 das mit dem Überwachungssignal modulierte Prozesssignal und nicht das über die Eingangsstufe 760 kommende Prozesssignal unmittelbar an den Eingang der mikroprozessorgesteuerten Steuereinrichtung 770 und der Steuereinrichtung 780 angelegt wird.

Weiterhin ist zu beachten, dass die Steuereinrichtung 780 unabhängig von der mikroprozessorgesteuerten Steuereinrichtung 770 die Ausgangsstufe 790 ansteuern kann. Hierzu ist beispielsweise eine Versorgungsspannung $V_{cc}$ vorgesehen, die über einen als Schalter fungierenden Transistor 782 an das Relais 795 der Ausgangsstufe 790 angelegt werden kann. An dieser Stelle sei bereits angemerkt, dass bei leitendem Zustand der Schalttransistoren 778 und 782 ein Strom durch das Relais 785 fließt.

Wie in Fig. 12 gezeigt, weist die Steuereinrichtung 780 neben dem Schalttransistor 782 das Monoflop 784 auf, welches einen mit $\overline{Q}$ bezeichneten negativen Ausgang aufweist, der vorzugsweise über einen Widerstand 788 mit der Steuerelektrode des Schalttransistors 782 verbunden ist. Ferner weist das Monoflop 784 einen Eingang A auf, an den das von der Eingangsstufe 760 kommende modulierte Eingangssignal angelegt wird. Weiter ist eine Reihenschaltung aus einem Kondensator 781 und einem Widerstand 783 vorgesehen, über die im Einschaltzeitpunkt der Sicherheitsvorrichtung 750 ein vorbestimmtes Spannungspotential an einen mit MR gekennzeichneten Master-Reset-Eingang angelegt wird, das bewirkt, dass das Monoflop am Q-Ausgang einen High-Pegel erzeugt.

Damit die als Master fungierende mikroprozessorgesteuerte Steuereinrichtung 770 Fehler in der Eingangsstufe 760 und in der Steuereinrichtung 780 erkennen kann, sind der Ausgang des UND-Gatters 762 der Eingangsstufe 760 und der Ausgang der Steuereinrichtung 780 jeweils mit einem Eingang der mikroprozessorgesteuerten Steuereinrichtung 770 verbunden. Da die Eingangsgrößen und die Übertragungsfunktion der Steuereinrichtung 780 der mikroprozessorgesteuerten Steuereinrichtung 770 bekannt sind, kann ein ordnungsgemäßer Betrieb der Eingangsstufe 760 und der Steuereinrichtung 780 durch die rückgekoppelten Ausgangssignale verifiziert werden. Die Referenz-Parameter der Eingangsgrößen und der Übertragungsfunktion der Steuereinrichtung 80 können im Speicher 774 der Steuereinrichtung 770 abgelegt werden. Sollte ein Fehler auftreten, so kann sowohl die Steuereinrichtung 780 als auch die mikroprozessorgesteuerte Steuereinrichtung 770 die Ausgangsstufe 90 in einen sicheren Zustand überführen, indem entweder der über den Schalttransistor 776 und die Verbindungsleitung 100 gebildete Massepfad geöffnet und/oder die Versorgungsspannung mittels des Schalttransistors 82 der Steuereinrichtung 780 von dem Relais 795 der Ausgangsstufe 790 abgeschaltet wird.

Bei der Realisierung der in Fig. 10 dargestellten asymmetrischen zweikanaligen Sicherheitsvorrichtung 750 ist ein kritischer Aspekt darin zu sehen, dass ein fehlerhaftes, unkontrolliertes Oszillieren des Life-Signals auftreten kann, welches ein sicheres Abschalten einer sicherheitstechnischen Einrichtung verhindern kann.

Eine Sicherheitsvorrichtung zur Lösung dieses Problems ist in Fig. 13 dargestellt. Die in dem in Fig. 1 dargestellten Sicherheitsschaltgerät 900 beispielhaft verwendete Sicherheitsvorrichtung 810 weist ähnlich der in Fig. 10 gezeigten Sicherheitsvorrichtung 750 eine Eingangsstufe 760 auf, die wiederum eine logische Verknüpfungseinrichtung, beispielsweise ein UND-Gatter 762 aufweisen kann. An einem Eingang des UND-Gatters 762 ist das Eingangssignal, welches das Prozesssignal sein kann, angelegt. Wiederum ist eine Ausgangsstufe 790 vorgesehen, die mehrere zusammenwirkende Schaltelemente 795 aufweisen kann, die ein definiertes Abschalten der sicherheitstechnischen Einrichtung ermöglicht. Die Sicherheitsvorrichtung 810 ist wiederum mehrkanalig, im vorliegenden Beispiel zweikanalig ausgebildet, wobei eine erste, mikroprozessorgesteuerte Steuereinrichtung 820 als Master und eine zweite Steuereinrichtung 840 als Slave fungiert. Wiederum kann die Steuereinrichtung 820 als softwarebasiertes Subsystem betrachtet werden, während die Steuereinrichtung 840 als hardwarebasiertes Subsystem ausgebildet sein kann, welches in Fig. 14 näher dargestellt ist.

Die mikroprozessorgesteuerte Steuereinrichtung 820 weist wiederum einen Mikroprozessor 822 auf, der ein niederfrequentes Überwachungs- oder Life-Signal erzeugen kann. Wiederum kann der Mikroprozessor 822 bei Beginn der Durchführung eines sicherheitsrelevanten Programms eine steigende Flanke und beim Verlassen der Ausführung des sicherheitsrelevanten Programms eine fallende Flanke erzeugen. Der zeitliche Abstand aufeinanderfolgender Impulse, das heißt die Periodizität des Überwachungssignals ist wiederum durch die Monozeit $T_m$ eines Monoflops definiert. Im Unterschied zur Sicherheitsvorrichtung 750 gemäß Fig. 10 wird das vom Mikroprozessor 822 erzeugte Überwachungssignal einem Modulator 824 zugeführt, der das niederfrequente Überwachungssignal mit einem hochfrequenten Modulationssignal, welches beispielsweise das Taktsignal des Mikroprozessors 822, ein aus dem Taktsignal abgeleitetes Signal oder ein anderes hochfrequentes Signal sein kann, moduliert. In diesem Fall wird das Taktsignal des Mikroprozessors 822 an einen zweiten Eingang des Modulators 824 angelegt. Das vom Modulator 824 erzeugte modulierte Überwachungssignal wird einem weiteren Eingang des UND-Gatters 762 der Eingangsstufe und einem ersten Eingang der Steuereinrichtung 830 zugeführt. Am Ausgang des UND-Gatters 762 erscheint ein moduliertes Prozesssignal, welches durch das von der mikroprozessorgesteuerten Steuereinrichtung 820 gelieferte modulierte Überwachungssignal moduliert wird. Das modulierte Ausgangssignal des UND-Gatters 762 wird jeweils als ein moduliertes Eingangssignal an einen Eingang der mikroprozessorgesteuerten Steuereinrichtung 820 und an einen weiteren Eingang der Steuereinrichtung 840 angelegt. Der Mikroprozessor 822 ist wiederum in der Lage, das vom UND-Gatter 762 kommende Ausgangssignal hinsichtlich eines Fehlers zu überwachen. In einem Speicher 826 können Eingangsgrößen, die die Eingangsstufe 760 betreffen, sowie die Übertragungsfunktion der Steuereinrichtung 830 abgelegt sein. Der Mikroprozessor 722 ist mit der Steuerelektrode, im vorliegenden Beispiel mit der Basis eines Schalttransistors 828 verbunden, der über eine Verbindungsleitung 800 die Ausgangsstufe 790 mit Masse verbinden kann. Der Schalttransistor 828 kann beispielsweise als Bipolartransistor vom NPN-Typ ausgebildet sein. Beispielsweise ist die Emitterelektrode des Schalttransistors 828 mit Masse und die Elektroelektrode des Schalttransistors 828 mit dem Eingang der Ausgangsstufe 790 verbunden. Erkennt der Mikroprozessor 822 einen Fehler, so kann er den über den Schalttransistor 828 und die Verbindungsleitung 100 gebildeten Massepfad auftrennen, indem er einen Low-Pegel an die Steuerelektrode des Schalttransistors 828 anlegt, so dass der Schalttransistor sperrt.

Das Ausgangssignal der Steuereinrichtung 840 ist eingangsseitig mit der mikroprozessorgesteuerten Steuereinrichtung 820 verbunden. Der Mikroprozessor 822 ist wiederum derart implementiert, dass er unter Berücksichtigung der abgelegten Übertragungsfunktion der Steuereinrichtung 840 ein Fehlverhalten der Steuereinrichtung 830 erkennen kann. Die Steuereinrichtung 840 weist einen Demodulator 840 auf, der in Fig. 14 detaillierter dargestellt ist.

Der Ausgang des Demodulators 830 kann mit der Steuerelektrode eines Schalttransistors 850 verbunden sein, über den eine Versorgungsspannung an die Ausgangsstufe 790 angelegt werden kann. Der Demodulator 830 weist ein Monoflop 831 auf, welches in seiner Funktion dem Monoflop 784 der in Fig. 12 gezeigten Steuereinrichtung 780 entspricht. Das Monoflop 731 weist einen mit A gekennzeichneten Eingang auf, an den das vom UND-Gatter 762 kommende modulierte Eingangssignal angelegt wird. Das vom Modulator 824 gelieferte modulierte Überwachungssignal wird einem Hochpassfilter 832 und einem mit TP2 bezeichneten Tiefpassfilter 833 zugeführt. Das Ausgangssignal des Hochpassfilters 832 wird einem weiteren Monoflop 834 zugeführt. Das Monoflop 834 weist einen Master-Reset-Eingang auf, an dem eine Versorgungsspannung $V_{cc}$ über eine Reihenschaltung, die einen Kondensator 835 und einen Widerstand 836 aufweist, angelegt werden kann. Der negierte Ausgang des Monoflops 834 wird an den Eingang eines weiteren, mit TP1 bezeichneten Tiefpassfilters 837 angelegt. Der Ausgang des Tiefpassfilters 833 ist mit einem ersten, mit A bezeichneten Eingang eines weiteren Monoflops 838 verbunden, während der Ausgang des Tiefpassfilters 837 mit dem Master-Reset-Eingang des Monoflops 838 verbunden ist. Der mit $\overline{Q}$ bezeichnete negative Ausgang des Monoflops 838 ist schließlich mit dem Master-Reset-Eingang des Monoflops 831 verbunden. Der mit $\overline{Q}$ bezeichnete negative Ausgang des Monoflops 831 ist mit der Steuerelektrode, im vorliegenden Beispiel mit der Basis des Schalttransistors 850 verbunden.

Die in den Figuren 15a bis 15i dargestellten Kurvenverläufe sind Eingangs- beziehungsweise Ausgangssignale an vorbestimmten Beobachtungspunkten innerhalb des Demodulators 830, welche mit den Nummern 1 bis 7 entsprechend gekennzeichnet sind. Die Spannungsverläufe treten bei einem ordnungsgemäßen Betrieb der Sicherheitsvorrichtung 810 auf. Bei einem fehlerhaften Betrieb der Steuereinrichtung 820 treten Spannungsverläufe auf, die in den Fig. 16a bis 16i bzw. 17a bis 17i gezeigt sind.

Nachfolgend wird die Funktionsweise der beiden in den Figuren 10 und 13 dargestellten Sicherheitsvorrichtungen 750 beziehungsweise 810 näher erläutert. Insbesondere wird die Funktionsweise der Steuereinrichtung 80 gemäß Fig. 10 und die Funktionsweise der in Fig. 13 gezeigten Steuereinrichtung 840 näher beschrieben.

Zunächst wird die Funktionsweise der in Fig. 10 gezeigten Steuereinrichtung 780 in Verbindung mit den Figuren 11 und 12 näher erläutert.

Es sei der Fall angenommen, dass eine sicherheitstechnische Automatisierungsanlage, zu der die Sicherheitsvorrichtung 750 gehört, in Betrieb genommen werden soll. Zu Beginn wird über den Kondensator 781 und den Widerstand 783 ein Spannungspotential an den Master-Reset-Eingang MR des Monoflops 784 angelegt, das bewirkt, dass der negative Ausgang $\overline{Q}$ des Monoflops 784 auf einen High-Pegel gesetzt wird, wodurch der Schalttransistor 782 in den sperrenden Zustand versetzt wird. Dies wiederum bewirkt, dass die Versorgungsspannung $V_{cc}$ über den Schalttransistor 782 nicht an die Ausgangsstufe 790 angelegt wird. Hierdurch wird sichergestellt, dass die Ausgangsstufe 790 erst in Betrieb genommen werden kann, wenn eine Versorgungsspannung angelegt wird und die Durchführung von Selbsttests abgeschlossen ist.

Nach einer durch den Widerstandswert des Widerstandes und der Kapazität des Kondensators definierten Zeit nimmt das Spannungspotential am Master-Reset-Eingang des Monoflops 784 ab, so dass der Ausgang $\overline{Q}$ durch das am Eingang A anliegenden modulierten Eingangssignal, welches vom UND-Gatter 762 geliefert wird, abhängt. Angenommen sei, dass am UND-Gatter 762 der Eingangsstufe 760 ein Prozesssignal mit einem High-Pegel anliegt, so dass bei ordnungsgemäßer Funktion der Steuereinrichtung 70 das in Fig. 11 dargestellte Überwachungssignal als moduliertes Eingangssignal am Eingang A des Monoflops 784 anliegt. Mit der ersten positiven Flanke des modulierten Eingangssignals wird der Ausgang $\overline{Q}$ des Monoflops 784 für die Monozeit $T_m$ auf Low gesetzt. Während dieser Zeit wird auch der Schalttransistor 782 leitend gehalten. Tritt, wie dies in Fig. 11 dargestellt ist, vor Ablauf der Monozeit $T_m$ eine weitere positive Flanke im Überwachungssignal auf, wird das Monoflop 784 erneut getriggert und der Ausgang $\overline{Q}$ wird wiederum für die Monozeit $T_m$ auf Low gesetzt. Solange der Mikroprozessor 772 der mikroprozessorgesteuerten Steuereinrichtung 770 ordnungsgemäß arbeitet, wird jeweils vor Ablauf der Monozeit $T_m$ eine positive Flanke erzeugt. Solange die Automatisierungsanlage, die Steuereinrichtungen 770 und 780 sowie die Eingangsstufe 760 ordnungsgemäß arbeiten, wird der Schalttransistor 782 über das Monoflop 784 im leitenden Zustand gehalten. Ordnungsgemäßer Betrieb heißt, dass das Eingangssignal oder Prozesssignal am Eingang des UND-Gatters 762 der Eingangsstufe 760 einen High-Pegel aufweist und das modulierte Eingangssignal ein Wechselsignal ist, dessen Periodendauer kleiner oder gleich der Monozeit $T_m$ ist.

Tritt nunmehr in der Steuereinrichtung 770 oder der Eingangsstufe 760 ein Fehler auf, sorgt das Monoflop 784 dafür, dass der Schalttransistor 782 in den sperrenden Zustand geschaltet und somit die Ausgangsstufe 790 von der Versorgungsspannung $V_{cc}$ getrennt wird. Ein Fehler kann zum Beispiel auch dadurch signalisiert werden, dass ein Prozesssignal mit einem Low-Pegel erzeugt wird, das dafür sorgt, dass der Ausgang des UND-Gatters 762 auf Null gesetzt wird. Demzufolge gelangt das Überwachungssignal nicht mehr an den Eingang A des Monoflops 782. Da am Eingang A des Monoflops innerhalb der Monozeit $T_m$ keine positive Flanke mehr erscheint, wird der Ausgang Q des Monoflops 784 auf Null gesetzt. Dies führt dazu, dass der Schalttransistor 782 sperrt und somit die Versorgungsspannung von der Ausgangsstufe 790 getrennt wird. Die Automatisierungsanlage kann nunmehr in einen gesicherten Zustand gefahren werden.

Zudem kann ein Fehler in der Steuereinrichtung 770 auftreten, wenn beispielsweise der Mikroprozessor 772 aufgrund eines nicht vorhersehbaren Fehlers ein sicherheitsrelevantes Programm nicht startet. In diesem Fall bleibt das Überwachungssignal beispielsweise kontinuierlich auf einem Low-Pegel. Das wiederum dazu führt, dass über eine Zeitspanne, die Länger als die Monozeit $T_m$ des Monoflops 784 ist, keine positive Flanke am Eingang A des Monoflops 784 auftritt, so dass der Schalttransistor 782 in den sperrenden Zustand versetzt wird. In ähnlicher Weise wird das Überwachungssignal auf einem High-Pegel verharren, wenn der Mikroprozessor 772 zwar ein sicherheitsrelevantes Programm gestartet hat, dieses aber aufgrund eines nicht vorhersehbaren Fehlers nicht mehr beenden kann. Auch dieser Zustand führt wiederum dazu, dass über eine Zeitspanne, die Länger als die Monozeit $T_m$ des Monoflops 784 ist, keine positive Flanke am Eingang A des Monoflops 784 auftritt, so dass der Schalttransistor 782 in den sperrenden Zustand versetzt und die Ausgangsstufe 790 in einen gesicherten, vordefinierten Zustand gefahren wird. Angemerkt sei an dieser Stelle, dass je nach Realisierung der Steuereinrichtung 780 das Monoflop 784 auch durch fallende Flanken getriggert werden kann.

Dank der asymmetrischen, zweikanaligen Sicherheitsvorrichtung 750 ist es möglich, eine Automatisierungsanlage oder deren sicherheitstechnischen Komponenten bei Auftritt eines Fehlers, der seine Ursache zum Beispiel in der Eingangsstufe 760 oder der Sicherheitseinrichtung 770 hat, in einen sicheren Zustand zu gefahren.

Ein Fehler in der Steuereinrichtung 780 wird von der Steuereinrichtung 770 erkannt, indem das Ausgangssignal der Steuereinrichtung 780 über die Rückkopplungsleitung 805 zum Mikroprozessor 772 geführt wird. Denn die Steuereinrichtung 770 kennt die Übertragungsfunktion der Steuereinrichtung 780, die im Speicher 774 hinterlegt sein kann. Erkennt die Steuereinrichtung 770 einen Fehler im Ausgangssignal der Steuereinrichtung 780, sorgt der Mikroprozessor 772 dafür, dass der Schalttransistor 776 gesperrt und somit der Massepfad zur Ausgangsstufe 790 geöffnet wird.

Anzumerken sei noch, dass das Monoflop 784 ferner dazu dient, die Einschaltzeit des angelegten modulierten Eingangssignals um die Monozeit $T_m$ zu verlängern, so dass auch nach dem Abschalten des Eingangssignals oder Prozesssignals die Ausgangsstufe 790 noch kontrolliert in einen gesicherten Zustand gesteuert werden kann. Um die Sicherheitsbedingungen, die zum gesicherten Abschalten einer Automatisierungsanlage erforderlich sind, einhalten zu können, darf die Monozeit $T_m$ nicht länger als die Sicherheitsabschaltzeit der Ausgangsstufe 90 sein.

Nachfolgend wird die Funktionsweise der in Fig. 13 dargestellten asymmetrischen zweikanaligen Sicherheitsvorrichtung 810 in Verbindung mit den Figuren 14 bis 17i näher erläutert.

Der in Fig. 14 gezeigte Demodulator 130 der Steuereinrichtung 840 weist im Unterschied zu der in Fig. 12 gezeigten Schaltungsanordnung eine Tiefpass- und Hochpassanordnung auf, durch die quasi eine digitale Bandsperre realisiert wird. Bei korrekter Dimensionierung der Baukomponenten und ordnungsgemäßer Funktionsweise der Sicherheitsvorrichtung 810 verhält sich der Demodulator 830 ähnlich dem in Fig. 12 gezeigten Monoflop 784. Tritt jedoch in der Steuereinrichtung 820, beispielsweise im Mikroprozessor 822 ein Fehler auf, so wird je nach Fehlerfall der hochfrequente und niederfrequente Anteil des vom Modulator 824 kommenden modulierten Überwachungssignals zu höheren oder niedrigeren Frequenzen verschoben. Die Folge davon ist, dass entweder der hochfrequente oder niederfrequente Anteil des modulierten Überwachungssignals durch das Bandsperrverhalten des Demodulators 830 gesperrt wird. Dies führt dazu, dass das Monoflop 831 nach Ablauf der Monozeit den positiven Ausgang Q auf Low setzt, wodurch der Schalttransistor 850 in den sperrenden Zustand versetzt und somit die Ausgangsstufe 790 in einen sicheren Zustand gefahren wird. Angemerkt sei noch, dass die Steuereinrichtung 720 ein Softwaremodul aufweist, welches dafür sorgt, dass eine Veränderung des Taktes des Mikroprozessors 720 zu einer entsprechenden Frequenzverschiebung des Life-Signals führt.

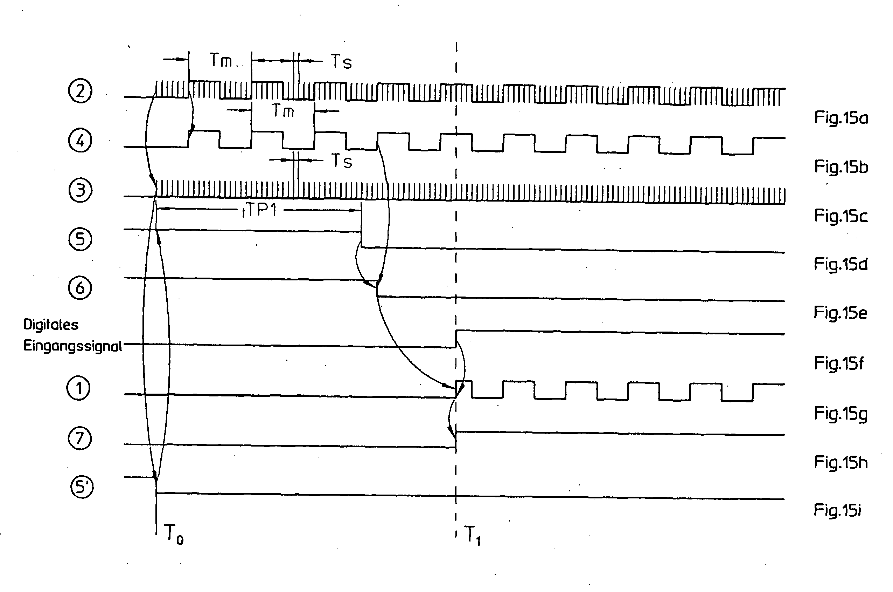

Die Funktionsweise des Demodulators 830 wird anhand der Fig. 15 bis 17i detailliert beschrieben. Zunächst wird der fehlerfreie Betrieb der Steuereinrichtung 820 geschildert.

Bei einem fehlerfreien Betrieb der Sicherheitsvorrichtung 810 treten an den in Fig. 14 eingezeichneten Beobachtungspunkten die in den Figuren 15a bis 15i gezeigten Signalverläufe auf.

Wir betrachten zunächst den Zeitraum von $T_0$ bis $T_1$. Angenommen sei, dass bis zum Zeitpunkt $T_1$ an das UND-Gatter 762 kein Prozessignal angelegt wird, wie dies in Fig. 15f gezeigt ist. Somit liegt bis zum Zeitpunkt $T_1$ am Eingang A des Monoflops 831 kein Signal an, wie dies in Fig. 15g gezeigt ist. Fig. 15a zeigt schematisch das modulierte Überwachungssignal, welches eine Überlagerung des Taktsignals des Mikroprozessors 822 und des in Fig. 11 gezeigten Überwachungssignals ist. In dem dargestellten Kurvenverlauf, der bereits zum Zeitpunkt $T_0$ beginnt, fällt die Periodendauer des Überwachungssignals etwa mit der Monozeit $T_m$ des Monoflops 831 zusammen. Das vom Modulator 824 der Steuereeinrichtung 820 als Modulationssignal verwendete Taktsignal des Mikroprozessors 822 weist eine Periodendauer von $T_s$ auf, die ebenfalls in Fig. 15a eingetragen ist. An dieser Stelle sei noch erwähnt, dass die Kapazität 835 und den Widerstand 836 aufweisende Reihenschaltung dazu dient, im Einschaltzeitpunkt der Automatisierungsanlage ein Spannungspotential an den Master-Reset-Eingang des Monoflops 834 anzulegen, der zum Zeitpunkt $T_0$ für einen Low-Pegel am negierten Ausgang $\overline{Q}$ des Monoflops 834 sorgt, wie dies in Fig. 15i gezeigt ist.

Fig. 15b zeigt den niederfrequenten Anteil des modulierten Überwachungssignal, welcher am Ausgang des Tiefpassfilters 833 anliegt. Fig. 15c zeigt den hochfrequenten Anteil des modulierten Überwachungssignals, welcher am Ausgang des Hochpassfilters 832 anliegt. Fig. 15i zeigt den am negierten Ausgang $\overline{Q}$ des Monoflops 834 anliegenden Signalverlauf, der zum Zeitpunkt $T_0$, wenn das modulierte Eingangssignal gemäß Fig. 15a an das Hochpassfilter 832 angelegt wird, auf Null geht, da positive Flanken des in Fig. 15c gezeigten hochfrequenten Signalanteils jeweils vor Ablauf der speziellen Monozeit des Monoflops 834 dieses triggern. Fig. 15d zeigt den am Ausgang des Tiefpassfilters 837 anliegenden Signalverlauf, der nach einer vorbestimmten Laufzeit den Wert des Signalverlaufs nach Fig. 15i, d. h. den Wert Null annimmt. Fig. 15e zeigt den am negierten Ausgang $\overline{Q}$ des Monoflops 838 anliegenden Signalverlauf. Fig. 15h zeigt den Signalverlauf am Ausgang Q des Monoflops 831.

Zum Zeitpunkt $T_1$ werde nunmehr ein Prozessignal, welches auch ein Sensorsignal sein kann, mit einem High-Pegel an das UND-Gatter 762 angelegt, wie in Fig. 15f gezeigt. Von diesem Zeitpunkt an liefert das UND-Gatter 762 das in Fig. 15g gezeigte Wechselsignal. Dieses Signal enthält im vorliegenden Beispiel aufgrund systembedingter Tiefpasseigenschaften keine Hochfrequenzanteile mehr. Vielmehr entspricht es dem Überwachungssignal mit einer Periodendauer von kleiner oder gleich $T_m$.

Da im ordnungsgemäßen Betrieb am negierten Ausgang $\overline{Q}$ des Monoflops 838 ein Low-Pegel gemäß Fig. 15e anliegt " der gleichzeit am Master-Reset-Eingang des Monoflops 831 anliegt, wird dessen Verhalten vom modulierten Eingangssignal nach Fig. 15g bestimmt. Da die Periodendauer des modulierten Eingangssignals, wie gesagt, kleiner der Monozeit $T_m$ des Monoflops 831 ist, wird das Monoflop 831 regelmäßig getriggert. Demzufolge liefert der Ausgang Q des Monoflops 831 einen High-Pegel, wie in Fig. 15h dargestellt. Dies hat wiederum zur Folge, dass der Schalttransistor 850 im leitenden Zustand gehalten und die Ausgangsstufe mit Energie versorgt wird.

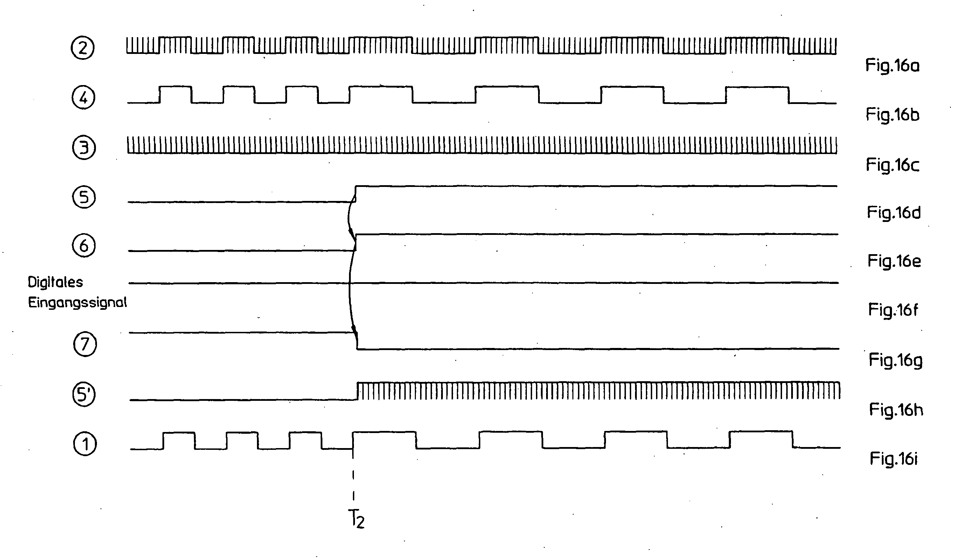

Nunmehr sei der Fehlerfall angenommen, dass die Frequenz des Taktes des Mikroprozessors 822 zum Zeitpunkt $T_2$ sinkt. Dies ist in Fig. 16a für das modulierte Überwachungssignal, welches am Eingang des Hochpassfilters 832 und am Eingang des Tiefpassfilters 833 angelegt wird, dargestellt. Wie ersichtlich ist, ist der zeitliche Abstand der Taktimpulse nach dem Zeitpunkt $T_2$ länger. Demzufolge zieht eine Verlängerung der Periodendauer des Taktsignals des Mikroprozessors 822 eine Verlängerung der Periodendauer des Überwachungssignals nach sich. Auch dieser Sachverhalt ist in Fig. 16a dargestellt. Fig. 16f zeigt, dass nach wie vor ein Prozesssignal mit High-Pegel am UND-Gatter 762 anliegt, welches normalen Betriebszustand der Anlage darstellt. Fig. 16b zeigt die Veränderung des Ausgangssignals am Tiefpassfilter 833 nach dem Zeitpunkt $T_2$, nachdem die Frequenz des Taktsignals des Mikroprozessors 822 gesunken ist.

Fig. 16c zeigt die Änderung des Taktsignals des Mikroprozessors 822 zum Zeitpunkt $T_2$. Da der zeitliche Abstand aufeinander folgender positiver Flanken im Taktsignal des Mikroprozessors 822 zum Zeitpunkt $T_2$ länger als die Monoflopzeit des Monoflops 834 ist, erscheint am negierten Ausgang $\bar{Q}$ des Monoflops 834 das in Fig. 16h dargestellte hochfrequente Taktsignal des Mikroprozessors 822. Das Tiefpassfilter 837 filtert die hochfrequenten Anteile aus dem Ausgangssignal am negierten Ausgang $\bar{Q}$ des Monoflops 834 heraus, so dass am Ausgang des Tiefpassfilters 837 nach Ablauf der Monozeit des Monoflops 834 ein High-Pegel anliegt, wie er in Fig. 16d dargestellt ist. Der High-Pegel wird an den Master-Reset-Eingang des Monoflops 838 angelegt und sorgt dafür, dass am negierten Ausgang des Monoflops 838 ein High-Pegel erzeugt wird, der in Fig. 16e dargestellt ist. Demzufolge wird über den Master-Reset-Eingang des Monoflops 831 ein Ausgangssignal mit Low-Pegel erzeugt, wie in Fig. 16g gezeigt. Dieses Signal steuert den Schalttransistor 850 in den gesperrten Zustand. Demzufolge wird die Versorgungsspannung von der Ausgangsstufe 790 abgetrennt, so dass die Ausgangsstufe 790 eine sicherheitstechnische Einrichtung in einen sicheren Zustand fahren kann.

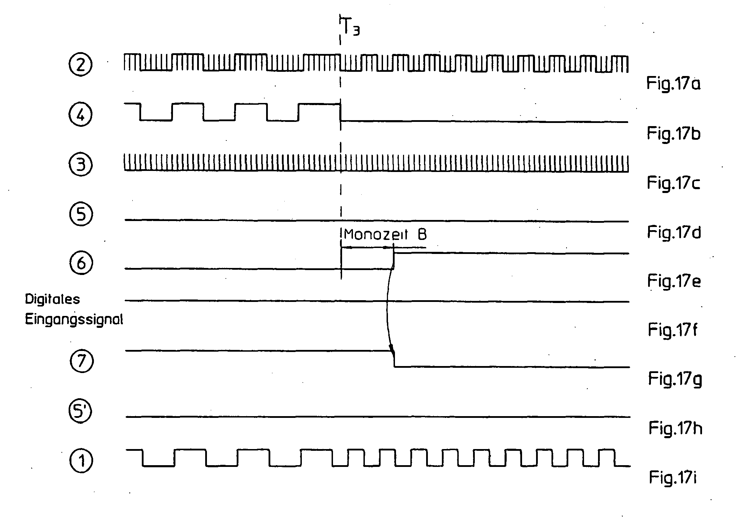

Die Signalverläufe in den Figuren 17a bis 17i treten bei einem Fehler in der Steuereinrichtung 820 auf, der sich in einer Erhöhung der Taktfrequenz des Mikroprozessorsignals äußert. Fig. 17a zeigt das an dem Eingang des Hochpassfilters 832 und an dem Eingang des Tiefpassfilters 833 ankommende modulierte Überwachungssignal, welches sich zu einem Zeitpunkt $T_3$ wie dargestellt ändert. Immer noch sei angenommen, dass die Eingangsstufe 760 und die Automatisierungsanlage selbst fehlerfrei arbeiten, so dass am UND-Gatter 762 nach wie vor ein Prozesssignal mit einem High-Pegel anliegt, wie dies in Fig. 17f dargestellt ist.

Fig. 17i zeigt die Veränderung des modulierten Eingangssignals nach dem Zeitpunkt $T_3$, welches an den Eingang A des Monoflops 831 angelegt wird. Fig. 17c zeigt wiederum die Veränderung des Taktsignals am Ausgang des Tiefpassfilters 832 zum Zeitpunkt $T_3$. Das in Fig. 17c gezeigte hochfrequente Eingangssignal bewirkt, dass am negierten Ausgang des Monoflops 834 dauerhaft ein Low-Pegel anliegt, der in Fig. 17h dargestellt ist. Der Low-Pegel wird über das Tiefpassfilter 837 an den Master-Reset-Eingang des Monoflops 838 angelegt. Das Tiefpassfilter 833 ist derart dimensioniert, dass es auch den niederfrequenten Anteil des fehlerbehafteten modulierten Überwachungssignals, welches in Fig. 17a dargestellt ist, ab dem Zeitpunkt $T_3$ sperrt, wie dies durch den Spannungsverlauf in Fig. 17b dargestellt ist. Da am Eingang A des Monofloips 838 nur noch ein konstanter Pegel anliegt, wird nach Ablauf der Monozeit des Monoflops 838 der negierte Ausgang auf einen High-Pegel gesetzt, wie dies durch Fig. 17e dargestellt ist. Über den Master-Reset-Eingang MR wird nunmehr das Monoflop 831 rückgesetzt, wodurch der Ausgang des Monoflops 831 auf Null gesetzt wird, wie dies in Fig. 17g dargestellt ist. Wiederum wird der Schalttransistor 850 gesperrt und somit die Spannungsversorgung von der Ausgangsstufe 790 getrennt.

## Patentansprüche

1. Sicherheitsschaltgerät (900) zum Steuern wenigstens einer sicherheitstechnischen Einrichtung in einen gesicherten Zustand, mit

   einer ersten Anschlusseinrichtung (910) zum Anschalten des Sicherheitsschaltgerätes an eine ein- oder mehrphasige Energieversorgungseinrichtung,

   wenigstens einer zweiten Anschlusseinrichtung (920) zum Anschalten einer sicherheitstechnischen Einrichtung,

   einer dritten Anschlusseinrichtung (940, 945) zum Anschalten wenigstens einer sicherheitstechnischen Eingangsstufe (760),

   einer zwischen der ersten und zweiten Anschlusseinrichtung (910, 920) geschalteten ein- oder mehrphasigen Leistungsendstufe (200) mit wenigstens einem ansteuerbaren Schaltkontakt,

   einer Messeinrichtung (610),

   einer Sicherheitseinrichtung (820, 840) zum mehrkanaligen Ansteuern der Leistungsendstufe (200),

   wobei die Sicherheitseinrichtung (820, 840) folgende Merkmale aufweist:

   eine erste, eine programmierbare Steuereinheit (822) aufweisende Steuereinrichtung (820), die eine Einrichtung zum Erzeugen eines Überwachungssignals aufweist,

   eine zweite Steuereinrichtung (840),

   wobei die Eingangsstufe (760) mit der ersten, Steuereinrichtung (820) und der zweiten Steuereinrichtung (840) verbunden und zum Modulieren eines Eingangssignals mit dem von der ersten Steuereinrichtung (820) kommenden Überwachungssignal ausgebildet ist, wobei die erste, Steuereinrichtung (820) und/oder die zweite Steuereinrichtung (840) unter Ansprechen auf das modulierte Eingangssignal die sicherheitstechnische Einrichtung bei Auftritt eines Fehlers in einen vorbestimmten sicheren Zustand steuern,

wobei die erste Steuereinrichtung (820) der Messeinrichtung (610) zugeordnet und derart ausgebildet ist, dass sie unter Ansprechen auf ein gemessenes Analogsignal die sicherheitstechnische Einrichtung über die Leistungsendstufe (200) in einen vorbestimmten sicheren Zustand steuert, wenn ein vorbestimmter Parameter des gemessenen Analogsignals außerhalb eines vorbestimmten Arbeitsbereichs liegt.

2. Sicherheitsschaltgerät nach Anspruch 1,
**dadurch gekennzeichnet, dass**
die Leistungsendstufe (200) eine dreiphasige Leistungsendstufe ist und einen ersten, zweiten und dritten Leiter (210, 211, 212; 410, 411, 412; 510, 511, 512) aufweist, die über die erste Anschlusseinrichtung (910) mit einer Drehstromversorgungseinrichtung verbindbar sind, wobei jedem Leiter wenigstens ein ansteuerbarer Schaltkontakt (231, 232, 242; 451, 431, 432; 520, 531, 532) zum Öffnen und Schließen des jeweiligen Leiters zugeordnet ist, wobei die Ansteuerung von wenigstens zwei der Schaltkontakte unabhängig voneinander erfolgt.

3. Sicherheitsschaltgerät nach Anspruch 1 oder 2,
**dadurch gekennzeichnet, dass**
das gemessene Analogsignal einem periodischen Leiterstrom entspricht, und dass
die Messeinrichtung (610) eine Einrichtung (620, 630, 640, 650) zum Ermitteln der Zeitdauer, während der die Amplitude des zu messenden analogen Leiterstroms außerhalb des vorbestimmten Arbeitsbereichs liegt, und eine Auswerteeinrichtung (660) aufweist, die aus der ermittelten Zeitdauer und der Signalform, insbesondere der Signalfrequenz des zu messenden Leiterstroms dessen maximale Amplitude berechnet.

4. Sicherheitsschaltgerät nach Anspruch 3,
**dadurch gekennzeichnet, dass**
ein zweites gemessene Analogsignal einer Leiterspannung entspricht, und dass
die Messeinrichtung (610) eine Einrichtung zum Ermitteln der Wirkleistung enthält.

5. Sicherheitsschaltgerät nach einem der Ansprüche 1 bis 4, **dadurch gekennzeichnet, dass**
die Eingangsstufe (760) wenigstens eine sicherheitstechnische und/oder anwendungsabhängige Schalteinrichtung (765) aufweist.

6. Sicherheitsschaltgerät nach einem der Ansprüche 1 bis 5, **dadurch gekennzeichnet, dass**
der Mikroprozessor (822) das Überwachungssignal in Abhängigkeit von der Abarbeitung wenigstens eines sicherheitsrelevanten Programms erzeugt.

7. Sicherheitsschaltgerät nach einem der Ansprüche 1 bis 6,
**dadurch gekennzeichnet, dass**
die erste Steuereinrichtung (820) eine Einrichtung zum Überwachen der Eingangsstufe (760) und/oder der zweiten Steuereinrichtung und zum Erzeugen eines Fehlersignals aufweist, und dass
die erste Steuereinrichtung (820) unter Ansprechen auf das Fehlersignal die sicherheitstechnische Einrichtung in einen vorbestimmten sicheren Zustand steuert.

8. Sicherheitsschaltgerät nach einem der Ansprüche 1 bis 7,
**dadurch gekennzeichnet, dass**
die Eingangsstufe (70) eine Verknüpfungseinrichtung (762), insbesondere ein UND-Gatter zum Modulieren des Eingangssignals mit dem Überwachungssignal aufweist.

9. Sicherheitsschaltgerät nach einem der Ansprüche 1 bis 8,
**dadurch gekennzeichnet, dass**
die erste Steuereinrichtung (820) einen Modulator (824) zum Modulieren des Überwachungssignals mit einem Signal aufweist, dessen Frequenz höher als die Frequenz des Überwachungssignals ist, dass
die Eingangsstufe (70) zum Modulieren des modulierten Überwachungssignals mit dem Eingangssignal ausgebildet ist, dass
die zweite Steuereinrichtung (840) einen Demodulator (830) aufweist, der unter Ansprechen auf das von der Eingangsstufe (760) kommende modulierte Eingangssignal und das von der ersten Steuereinrichtung (820) kommende modulierte Überwachungssignal bei Auftritt eines Fehlers ein Steuersignal erzeugt, welches die sicherheitstechnische Einrichtung in den vorbestimmten sicheren Zustand steuert.

10. Sicherheitsschaltgerät nach Anspruch 9,
**dadurch gekennzeichnet, dass**
der Demodulator (830) ein Bandsperre und wenigstens eine Schalteinrichtung (831), insbesondere ein Monoflop, aufweist, die bei Veränderung der Frequenz des Signals mit höherer Frequenz um einen vorbestimmten Betrag ein Steuersignal zum Steuern der sicherheitstechnischen Einrichtung in den vorbestimmten sicheren Zustand liefert.

11. Sicherheitsschaltgerät nach einem der Ansprüche 1 bis 10,
**dadurch gekennzeichnet, dass**
das Eingangssignal ein binäres Prozesssignal ist.

12. Sicherheitsschaltgerät nach einem der Ansprüche 1 bis 11, **dadurch gekennzeichnet, dass**
die erste Anschlusseinrichtung (910), die wenigstens eine zweite Anschlusseinrichtung (920), die dritte Anschlusseinrichtung (949, 945), die Leistungsendstufe (200), die Messeinrichtung (610) und die Steuereinrichtungen (820, 840) auf einer Leiterplatte angeordnet sind.

## Claims

1. Safety switching apparatus (900) for controlling at least one safety-engineering device into a safe state, having
   a first connecting device (910) for switching on the safety switching apparatus at a single-phase or multi-phase energy supplying device,
   at least one second connecting device (920) for switching on a safety-engineering device,
   a third connecting device (940, 945) for switching on at least one safety-engineering input stage (760),
   a single-phase or multi-phase power output stage (200) which is connected between the first and second connecting device (910, 920) and has at least one triggerable switching contact,
   a measuring device (610),
   a safety device (820, 840) for the multi-channel triggering of the power output stage (200),
   wherein the safety device (820, 840) has the following features:

   a first control device (820) which comprises a programmable control unit (822) and a device for producing a monitoring signal,
   a second control device (840),
   wherein the input stage (760) is connected to the first control device (820) and the second control device (840) and is formed to modulate an input signal with the monitoring signal from the first control device (820),
   wherein the first control device (820) and/or the second control device (840) controls, in response to the modulated input signal, the safety-engineering device in the event of an error into a predetermined safe state,

   wherein the first control device (820) is allocated to the measuring device (610) and is formed such that it controls, in response to a measured analogue signal, the safety-engineering device via the power output stage (200) into a predetermined safe state if a predetermined parameter of the measured analogue signal is outside a predetermined operating range.

2. Safety switching apparatus as claimed in Claim 1, **characterised in that** the power output stage (200) is a three-phase power output stage and comprises a first, second and third conductor (210, 211, 212; 410, 411, 412; 510, 511, 512) which can be connected to a three-phase supplying device via the first connecting device (910), wherein each conductor is allocated at least one triggerable switching contact (231, 232, 242; 451, 431, 432; 520, 531, 532) for opening and closing the respective conductor, wherein at least two of the switching contacts are triggered independently of each other.

3. Safety switching apparatus as claimed in Claim 1 or 2, **characterised in that** the measured analogue signal corresponds to a periodic conductor current, and **in that** the measuring device (610) comprises a device (620, 630, 640, 650) for determining the length of time that the amplitude of the analogue conductor current to be measured is outside the predetermined operating range, and an evaluating device (660) which calculates, on the basis of the determined length of time and the signal form, in particular the signal frequency of the conductor current to be measured, its maximum amplitude.

4. Safety switching apparatus as claimed in Claim 3, **characterised in that** a second measured analogue signal corresponds to a conductor voltage, and **in that** the measuring device (610) contains a device for determining the active power.

5. Safety switching apparatus as claimed in any one of Claims 1 to 4, **characterised in that** the input stage (760) comprises at least one safety-engineering and/or application-dependent switching device (765).

6. Safety switching apparatus as claimed in any one of Claims 1 to 5, **characterised in that** the microprocessor (822) produces the monitoring signal in dependence upon the execution of at least one safety-relevant programme.

7. Safety switching apparatus as claimed in any one of Claims 1 to 6, **characterised in that** the first control device (820) comprises a device for monitoring the input stage (760) and/or the second control device and for producing an error signal, and **in that** the first control device (820) controls, in response to the error signal, the safety-engineering device into a predetermined safe state.

8. Safety switching apparatus as claimed in any one of Claims 1 to 7, **characterised in that** the input stage (70) comprises a combining device (762), in particular an AND gate for modulating the input signal with the monitoring signal.

9. Safety switching apparatus as claimed in any one of Claims 1 to 8, **characterised in that** the first control device (820) comprises a modulator (824) for modulating the monitoring signal with a signal whose frequency is higher than the frequency of the monitoring signal, **in that** the input stage (70) is formed to modulate the modulated monitoring signal with the input signal, **in that** the second control device (840) comprises a demodulator (830) which in the event of an error produces, in response to the modulated input signal from the input stage (760) and the modulated monitoring signal from the first control device (820), a control signal which controls the safety-engineering device into the predetermined safe state.

10. Safety switching apparatus as claimed in Claim 9, **characterised in that** the demodulator (830) comprises a band-stop filter and at least one switching device (831), in particular a monostable trigger circuit which, if the frequency of the signal with the higher frequency changes by a predetermined amount, produces a control signal for controlling the safety-engineering device into the predetermined safe state.

11. Safety switching apparatus as claimed in any one of Claims 1 to 10, **characterised in that** the input signal is a binary process signal.

12. Safety switching apparatus as claimed in any one of Claims 1 to 11, **characterised in that** the first connecting device (910), the at least one second connecting device (920), the third connecting device (949, 945), the power output stage (200), the measuring device (610) and the control devices (820, 840) are disposed on a printed circuit board.

**Revendications**

1. Appareil de commutation de sécurité (900) pour amener au moins un dispositif de sécurité dans un état bloqué, comprenant :

un premier dispositif de raccordement (910) pour la connexion de l'appareil de commutation de sécurité à un dispositif d'alimentation en énergie à une phase ou plusieurs phases,
au moins un second dispositif de raccordement (920) pour la connexion d'un dispositif de sécurité,
un troisième dispositif de raccordement (940, 945) pour la connexion d'au moins un étage d'entrée (760) de sécurité,
un étage final de puissance (200) à une ou plusieurs phases, commuté entre le premier et le second dispositif de raccordement (910, 920) avec au moins un contact de commutation actionnable,
un dispositif de mesure (610),
un dispositif de sécurité (820, 840) pour l'activation à plusieurs canaux de l'étage final de puissance (200), le dispositif de sécurité (820, 840), présentant les caractéristiques suivantes :

un premier dispositif de commande (820) présentant une unité de commande (822) programmable, qui présente un dispositif pour la génération d'un signal de contrôle,
un second dispositif de commande (840),
l'étage d'entrée (760) étant relié au premier dispositif de commande (820) et au second dispositif de commande (840) et étant conçu pour la modulation d'un signal d'entrée avec le signal de contrôle arrivant du premier dispositif de commande (820), le premier dispositif de commande (820) et/ou le second dispositif de commande (840), en réaction au signal d'entrée modulé, amenant le dispositif de sécurité dans un état sûr prédéfini, en cas d'apparition d'un défaut
le premier dispositif de commande (820) étant attribué au dispositif de mesure (610) et conçu de telle sorte que, en réaction à un signal analogique mesuré, il amène le dispositif de sécurité par l'intermédiaire de l'étage final de puissance (200) dans un état sûr prédéfini lorsqu'un paramètre prédéfini du signal analogique mesuré se situe en dehors d'une plage de travail prédéfinie.

2. Appareil de commutation de sécurité selon la revendication 1,
   **caractérisé en ce que** l'étage final de puissance (200) est un étage final de puissance à trois phases et présente un premier, un second et un troisième conducteur (210, 211, 212 ; 410, 411, 412 ; 510, 511, 512), qui peuvent être reliés par l'intermédiaire du premier dispositif de raccordement (910) à un dispositif d'alimentation en courant triphasé, au moins un contact de commutation (231, 232, 242 ; 451, 431, 432 ; 520, 531, 532) actionnable étant attribué à chaque conducteur pour l'ouverture et la fermeture du conducteur respectif, l'activation d'au moins deux des contacts de commutation s'effectuant indépendamment l'un de l'autre.

3. Appareil de commutation de sécurité selon la revendication 1 ou 2,
   **caractérisé en ce que**
   le signal analogique mesuré correspond à un courant de conducteur périodique, et **en ce que**
   le dispositif de mesure (610) présente un dispositif (620, 630, 640, 650) pour la détermination de la durée pendant laquelle l'amplitude du courant de conducteur analogique à mesurer se situe en dehors de la plage de travail prédéfinie, et un dispositif d'analyse (660) qui calcule à partir de la durée déterminée et de la forme de signal, en particulier la fréquence de signal du courant de conducteur à mesurer, son amplitude maximale.

4. Appareil de commutation de sécurité selon la revendication 3,
   **caractérisé en ce que**
   un second signal analogique mesuré correspond à une tension de conducteur, et **en ce que** le dispositif de mesure (610) contient un dispositif pour la détermination de la puissance réelle.

5. Appareil de commutation de sécurité selon l'une des revendications 1 à 4,
   **caractérisé en ce que**
   l'étage d'entrée (760) présente au moins un dispositif de commutation (765) de sécurité et/ou dépendant de l'application.

6. Appareil de commutation de sécurité selon l'une des revendications 1 à 5,
   **caractérisé en ce que**
   le microprocesseur (822) génère le signal de contrôle en fonction de l'élaboration d'au moins un programme important au niveau de la sécurité.

7. Appareil de commutation de sécurité selon l'une des revendications 1 à 6,
   **caractérisé en ce que**
   le premier dispositif de commande (820) présente un dispositif pour contrôler l'étage d'entrée (760) et/ou le second dispositif de commande et pour générer un signal de défaut, et **en ce que** le premier dispositif de commande (820) amène en réaction au signal de défaut le dispositif de sécurité dans un état sûr prédéfini.

8. Appareil de commutation de sécurité selon l'une quelconque des revendications 1 à 7,
   **caractérisé en ce que**
   l'étage d'entrée (70) présente un dispositif d'enchaînement (762), en particulier une porte ET pour la modulation du signal d'entrée avec le signal de contrôle.

9. Appareil de commutation de sécurité selon l'une quelconque des revendications 1 à 8,
   **caractérisé en ce que**
   le premier dispositif de commande (820) présente un modulateur (824) pour la modulation du signal de contrôle avec un signal dont la fréquence est supérieure à la fréquence du signal de contrôle, **en ce que** l'étage d'entrée (70) est conçu pour la modulation du signal de contrôle modulé avec le signal d'entrée, **en ce que** le second dispositif de commande (840) présente un démodulateur (830), qui génère, en réaction au signal d'entrée modulé arrivant de l'étage d'entrée (760) et au signal de contrôle modulé arrivant du premier dispositif de commande (820), en cas d'apparition d'un défaut, un signal de commande qui amène le dispositif de sécurité dans l'état sûr prédéfini.

10. Appareil de commutation de sécurité selon la revendication 9,
**caractérisé en ce que**
le démodulateur (830) présente un blocage de bande et au moins un dispositif de commutation (831), en particulier un basculeur, qui, en cas de variation de la fréquence du signal avec une fréquence supérieure d'une valeur prédéfinie, fournit un signal de commande pour amener le dispositif de sécurité dans l'état sûr prédéfini.

11. Appareil de commutation de sécurité selon l'une des revendications 1 à 10,
**caractérisé en ce que**
le signal d'entrée est un signal de processus binaire.

12. Appareil de commutation de sécurité selon l'une quelconque des revendications 1 à 11,
**caractérisé en ce que**
le premier dispositif de raccordement (910), le, au moins un, second dispositif de raccordement (920), le troisième dispositif de raccordement (949, 945), l'étage final de puissance (200), le dispositif de mesure (610) et les dispositifs de commande (820, 840) sont disposés sur une plaque de circuits imprimés.

Fig.1

Fig.2

Fig.3

EP 1 911 058 B1

Fig.4

500

EP 1 911 058 B1

Fig.5

Fig.6

EP 1 911 058 B1

Fig.7

Fig.8

Fig.9

740

(Stand der Technik)

Subsystem
Kanal1

720

730

Subsystem
Kanal2

Ausgangsstufe

Eingangsstufe

710

Fig.10

Fig.11

EP 1 911 058 B1

Fig.12

781

788

Vcc

moduliertes
Eingangssignal

1Л

A

MR

Q̄

Q

782

783        784

EP 1 911 058 B1

Fig.13

EP 1 911 058 B1

Fig.14

EP 1 911 058 B1

Fig.15a

Fig.15b

Fig.15c

Fig.15d

Fig.15e

Fig.15f

Fig.15g

Fig.15h

Fig.15i

EP 1 911 058 B1

Fig.16a

Fig.16b

Fig.16c

Fig.16d

Fig.16e

Digitales
Eingangssignal

Fig.16f

Fig.16g

Fig.16h

Fig.16i

$T_2$

EP 1 911 058 B1

Fig.17a

Fig.17b

Fig.17c

Fig.17d

Fig.17e

Fig.17f

Fig.17g

Fig.17h

Fig.17i